# EUROPEAN PATENT SPECIFICATION

(11) **EP 4 199 679 B1**
(45) Date of publication and mention of the grant of the patent: **23.10.2024**
(21) Application number: 22211591.7
(22) Date of filing: 06.12.2022
(51) Int. Cl.: H10K 50/12, H10K 50/13

(54) **ORGANIC LIGHT-EMITTING DEVICE**
ORGANISCHE LICHTEMITTIERENDE VORRICHTUNG
DISPOSITIF ÉLECTROLUMINESCENT ORGANIQUE

(30) Priority: 20.12.2021 JP 2021206091; 04.03.2022 JP 2022033476
(43) Date of publication of application: 21.06.2023
(73) Proprietor: CANON KABUSHIKI KAISHA, Tokyo 146-8501 (JP)
(72) Inventor: MIYASHITA, Hirokazu, Tokyo, 146-8501 (JP); NISHIDE, Yosuke, Tokyo, 146-8501 (JP); YAMADA, Naoki, Tokyo, 146-8501 (JP); IWAWAKI, Hironobu, Tokyo, 146-8501 (JP); TAKAYA, Itaru, Tokyo, 146-8501 (JP); OHRUI, Hiroki, Tokyo, 146-8501 (JP); KAMATANI, Jun, Tokyo, 146-8501 (JP)
(74) Representative: TBK

(56) References cited:
- US-A1- 2021 139 417

## Description

### BACKGROUND OF THE INVENTION

### Field of the Invention

The present disclosure relates to an organic light-emitting device and in particular, to a white organic light-emitting device that emits white light.

### Description of the Related Art

In recent years, full-color displays including organic electroluminescent (EL) devices have been intensively studied and developed. Full-color displays are produced by the following two methods. In one method, different light-emitting layers are allocated to different pixels (elements). In the other method, a white organic EL device including a white-light-emitting layer and different color filters allocated to different pixels is used. For such a white organic EL device, two or more light-emitting materials are often used.

U.S. Patent Application Publication No. 2004-0241491 discloses a white organic light-emitting device in which two light-emitting layers having different emission colors are stacked.

However, the white organic light-emitting device disclosed in U.S. Patent Application Publication No. 2004/0241491 has a disadvantage with durability.

US 2021/139417 A1 discloses white OLEDs with two stacked light emitting layers comprising red and green dopants and a blue dopant, respectively.

### SUMMARY OF THE INVENTION

The present disclosure has been made in light of the foregoing disadvantages and provides an organic light-emitting device, in particular, a white organic light-emitting device, having improved durability characteristics.

The present disclosure in its first aspect provides an organic light-emitting device as specified in claims 1 to 9.

Further features of the present disclosure will become apparent from the following description of exemplary embodiments with reference to the attached drawings.

### BRIEF DESCRIPTION OF THE DRAWINGS

Fig. 1A is a schematic cross-sectional view of an example of a pixel of a display apparatus according to an embodiment of the present disclosure, and Fig. 1B is a schematic cross-sectional view of an example of a display apparatus including organic light-emitting devices according to an embodiment of the present disclosure.
Fig. 2 is a schematic view of an example of a display apparatus according to an embodiment of the present disclosure.
Fig. 3A is a schematic view of an example of an image pickup apparatus according to an embodiment of the present disclosure, and Fig. 3B is a schematic view of an example of an electronic apparatus according to an embodiment of the present disclosure.
Fig. 4A is a schematic view of an example of a display apparatus according to an embodiment of the present disclosure, and Fig. 4B is a schematic view of an example of a foldable display apparatus.
Fig. 5A is a schematic view of an example of a lighting apparatus according to an embodiment of the present disclosure, and Fig. 5B is a schematic view of an example of a moving object including an automotive lighting unit according to an embodiment of the present disclosure.
Fig. 6A is a schematic view illustrating an example of a wearable device according to an embodiment of the present disclosure, and Fig. 6B is a schematic view of another example of a wearable device according to an embodiment of the present disclosure.
Fig. 7A is a schematic view of an example of an image-forming apparatus according to an embodiment of the present disclosure,
   Fig. 7B is a schematic view of an example of an exposure light source of an image-forming apparatus according to an embodiment of the present disclosure, and
   Fig. 7C is a schematic view of an example of an exposure light source of an image-forming apparatus according to an embodiment of the present disclosure.

### DESCRIPTION OF THE EMBODIMENTS

An organic light-emitting device according to an embodiment of the present disclosure includes, in sequence, at least an anode, a first light-emitting layer, a second light-emitting layer, and a cathode. That is, the organic light-emitting device according to an embodiment of the present disclosure includes multiple light-emitting layers stacked. The first light-emitting layer adjacent to the anode contains at least a first host and a first guest that fluoresces. The second light-emitting layer adjacent to the cathode contains at least a second host and a second guest that fluoresces. The organic light-emitting device according to an embodiment of the present disclosure may be an organic EL device that emits light by energizing an organic EL layer including a light-emitting layer interposed between a pair of electrodes, particularly a white organic EL device that emits white light.

The first host and the second host in the respective light-emitting layers are each a hydrocarbon compound whose carbon atoms are SP² carbon atoms only and has any of structures represented by the following formulae [1] to [6]: 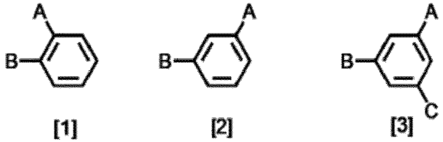 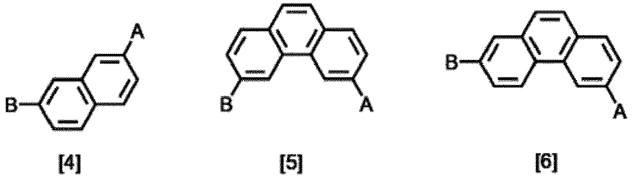 where in formula [1] to [6], A to C are each an anthracene residue, a pyrene residue, a benzanthracene residue, a benzpyrene residue, a phenanthrene residue, or a fluoranthene residue, and each of A to C optionally further contains a phenyl group, a biphenyl group, a terphenyl group, or a naphthyl group.

In an embodiment of the present disclosure, the term "light-emitting layer" refers to a layer having the function of emitting light among organic compound layers disposed between electrodes. The term "host" contained in a light-emitting layer refers to a material serving as a main component among materials contained in each light-emitting layer. More specifically, the terms "host" refers to a material whose content in a light-emitting layer is more than 50% by mass among materials contained in the light-emitting layer. The term "guest" refers to a material that is not a main component among the materials contained in the light-emitting layer. More specifically, the terms "guest" refers to a material whose content in the light-emitting layer is less than 50% by mass among the materials contained in the light-emitting layer. The concentration of the guest in the light-emitting layer is preferably 0.1% or more by mass and 20% or less by mass, more preferably 10% or less by mass in order to suppress concentration quenching.

In this specification, the phrase "emission in a blue region" indicates that the peak wavelength of an emission spectrum is in the range of 430 nm to 480 nm. The phrase "emission in a green region" indicates that the peak wavelength of an emission spectrum is in the range of 500 nm to 570 nm. The phrase "emission in a red region" indicates that the peak wavelength of an emission spectrum is in the range of 580 nm to 680 nm.

### Features

The organic light-emitting device according to the present embodiment has the following features and thus is an organic light-emitting device, particularly a white organic light-emitting device, having superior durability characteristics.
(1) Each of the first host and the second host is a hydrocarbon compound whose carbon atoms are SP² carbon atoms only. Moreover, each of the first light-emitting layer and the second light-emitting layer contains no amine compound.
(2) Each of the first host and the second host has any of structures represented by formulae [1] to [6].

These features will be described below.
(1) Each of the first host and the second host is a hydrocarbon compound whose carbon atoms are SP² carbon atoms only. Moreover, each of the first light-emitting layer and the second light-emitting layer contains no amine compound.

To accomplish the present disclosure, the inventors have focused attention on the bond strength of the structure of a host compound.

Specifically, each of the first host and the second host is a hydrocarbon compound whose carbon atoms are SP² carbon atoms only, and the inventors attempted to design its molecule in such a manner that the molecule has no structure having low bond stability. This is because a compound having a bond with low bond stability in its molecular structure, that is, having an unstable bond with low bond energy, deteriorates easily when the device is driven, and is highly likely to adversely affect the durability life of the organic light-emitting device.

For example, in the case of a compound [4,4'-bis(carbazol-9-yl)biphenyl] (CBP) illustrated below, the bonds having low bond stability are bonds (nitrogen-carbon bonds) connecting carbazole rings and phenylene groups. A comparison of calculated values of bond energies between CBP and exemplified compound EM2 as a host material is described below. The calculation method used was b3-lyp/def2-SV(P).

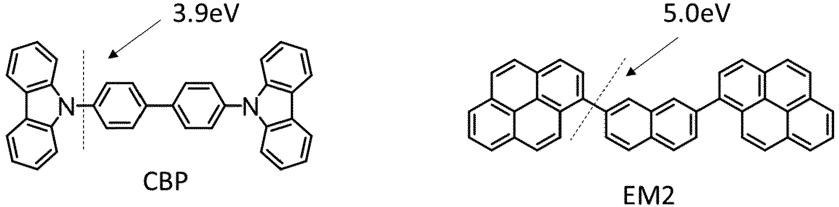

The above results reveal that the nitrogen-carbon bonds of CBP are bonds having low bond stability. Such a bond may not be included in the structure of the host material, especially in the light-emitting layer.

In contrast, bonds among condensed rings of exemplified compound EM2 consist of carbon-carbon bonds. And thus the exemplified compound EM2 has a structure with high bond stability.

Moreover, each of the first light-emitting layer and the second light-emitting layer contains no amine compound. An amine compound contains a carbon-nitrogen bond with low bond stability. Thus, the bond is easily cleaved during the driving of the device, thereby adversely affecting the driving durability of the device.

Moreover, the inventors attempted to design the molecule in such a manner that a substituent contained in the host material also has high bond stability. Table 1 presents bond dissociation energies of carbon-hydrogen bonds described in ACC. Chem. Res. 36, 255-263 (2003).

**Table 1**

| | Bond | Bond dissociation energy (Kcal/mol) | Hybrid orbital of carbon atom |
|---|---|---|---|
| Methyl group | 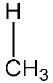 | 105 | SP³ |
| Ethyl group | 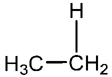 | 101 | SP³ |
| Benzyl group | 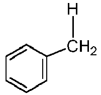 | 90 | SP³ |
| Phenyl group | 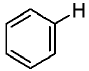 | 113 | SP² |

A larger value of the bond dissociation energy indicates a stronger bond, and a smaller value thereof indicates a weaker bond. Specifically, substituents containing SP³ carbon atoms, such as a methyl group, an ethyl group, and a benzyl group, are substituents that generate radicals by easily cleaving carbon-hydrogen bonds to eliminate hydrogen atoms.

As presented in Table 2, a structural comparison is made between exemplified compound EM10 serving as a host material and comparative compound 1.

**Table 2**

| | Structure | Number of bonds between SP³ carbon atoms and hydrogen atoms |
|---|---|---|
| Exemplified compound EM10 | 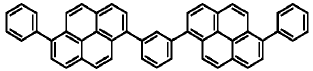 | 0 |
| Comparative compound 1 | 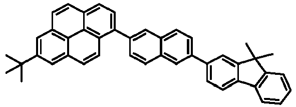 | 15 |

As presented in Table 2, the number of bonds between the SP³ carbon atoms and the hydrogen atoms in comparative compound 1 is 15. The use of this material as a host of an organic light-emitting device easily generates radicals owing to the elimination of the hydrogen atoms, thereby failing to achieve long-life durability characteristics. In contrast, exemplified compound EM10 contains no SP³ carbon atoms; thus, the number of bonds between SP³ carbon atoms and hydrogen atoms is zero. Specifically, exemplified compound EM10 is a compound whose carbon atoms are SP² carbon atoms only; thus, radicals are not easily generated, and long-life durability characteristics should be provided. Comparison of the durability characteristics of the devices will be described in detail in Examples.

As described above, each of the first host and the second host is the compound whose carbon atoms are SP² carbon atoms only and has superior durability characteristics; thus, the organic light-emitting device containing these compounds has superior durability characteristics. Moreover, each of the first host and the second host is the compound whose carbon atoms are SP² carbon atoms only, thereby resulting in high electron mobility. This should be effective in reducing the voltage of the device. (2) Each of the first host and the second host has any of structures represented by formulae [1] to [6].

As described in feature (1) above, each of the first host and the second host is the compound whose carbon atoms are SP² carbon atoms only, and thus is stable as a compound. Meanwhile, molecular aggregation due to π-π stacking of molecules occurs easily, thereby possibly deteriorating the film properties and sublimability. To suppress the molecular aggregation, as feature (2), each of the first host and the second host has any of structures represented by formulae [1] to [6], each structure reducing the linearity of the molecular structure: 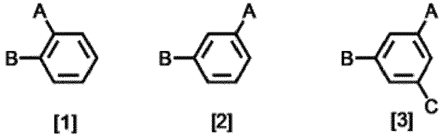 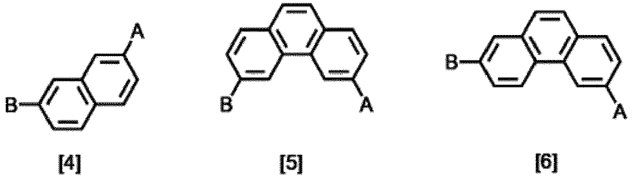 where in formula [1] to [6], A to C are each an anthracene residue, a pyrene residue, a benzanthracene residue, a benzpyrene residue, a phenanthrene residue, or a fluoranthene residue, and each of A to C optionally further contains a phenyl group, a biphenyl group, a terphenyl group, or a naphthyl group.

From the viewpoint of excitation energy, each of A to C can be a pyrene residue, an anthracene residue, or a phenanthrene residue, which has a sufficiently high S₁ energy level and thus should satisfactorily transfer energy to a guest. From the viewpoint of the glass transition temperature, a pyrene residue, in which four benzene rings are condensed and a high Tg should be provided, can be used.

Table 3 presents the comparisons of solubility test results between exemplified compound EM2 as a host material and comparative compound 2 and between exemplified compound EM4 as a host material and comparative compound 3. The solubility test was performed as follows: 100 mg of the host material was heated to reflux in toluene under stirring. The resulting amounts of toluene solvent when the host materials were dissolved were compared with each other. Table 3 presents the amount of toluene solvent required for completely dissolving comparative compound 2 when the amount of toluene solvent required for completely dissolving exemplified compound EM2 was defined as 1. Table 3 also presents the amount of toluene solvent required for completely dissolving comparative compound 3 when the amount of toluene solvent required for completely dissolving exemplified compound EM4 was defined as 1.

**Table 3**

| | Structure | Solubility test |
|---|---|---|
| Exemplified compound EM2 | 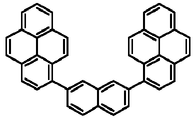 | 1 |
| Comparative compound 2 | 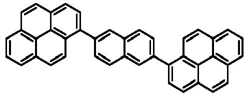 | 80 |
| Exemplified compound EM4 | 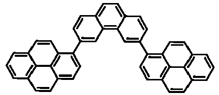 | 1 |
| Comparative compound 3 | 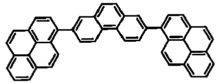 | 60 |

Table 3 indicates that although both exemplified compound EM2 and comparative compound 2 are compounds each composed of pyrene moieties and a naphthalene moiety, the solubilities of these compounds differ greatly in accordance with their binding positions. Table 3 indicates that although both exemplified compound EM4 and comparative compound 3 are compounds each composed of pyrene moieties and a phenanthrene moiety, the solubilities of these compounds also differ greatly in accordance with their binding positions.

Comparative compound 2 has a highly linear structure because the pyrene moieties are bonded to the 2,6-positions of the naphthalene moiety. In contrast, exemplified compound EM2 has a structure in which the pyrene moieties are bonded to the 2,7-positions of the naphthalene moiety, i.e., the structure being represented by formula [4]. As a result, this molecule has a bent structure; this seemingly contributes to its solubility. Similarly, comparative compound 3 has a highly linear structure because the pyrene moieties are bonded to the 2,7-positions of the phenanthrene moiety. In contrast, exemplified compound EM4 has a structure in which the pyrene moieties are bonded to the 3,6-positions of the phenanthrene moiety, i.e., the structure being represented by formula [5]. As a result, this molecule has a bent structure; this seemingly contributes to its solubility.

In the case of a compound having a highly linear molecular structure, its molecules aggregate easily because the molecules lie easily one on top of another. For this reason, from the viewpoint of material synthesis, the compound is not suitable for mass production because of its poor solubility. In addition, as a material for the organic light-emitting device, the compound may not be used because it leads to deteriorations in film properties and sublimability. In contrast, each of the first host and the second host has a bent structure; hence, its molecules are inhibited from lying one on top of another, and thus molecular aggregation does not easily occur. This results in good solubility, improved amorphous nature of a film, and improved sublimability.

In the organic light-emitting device, the film properties of the organic compounds contained in the device are important. This is because the high degree of amorphous nature is less likely to cause the formation of a crystal grain boundary and the formation of a trap level and a quencher due to microcrystallization even during the driving of the device, and thus can lead to the maintenance of good carrier transportability and highly efficient light-emitting characteristics. Hence, it is possible to provide the organic light-emitting device having superior durability and efficiency. Similarly, in the organic light-emitting device, the sublimability of the organic compounds contained in the device is important. This is because the high sublimability thereof results in stable sublimation purification without decomposition during the sublimation. This also indicates high stability of vapor deposition when the organic light-emitting device is produced. In other words, it is possible to form a high-pure vapor-deposited film without decomposition during the vapor deposition, and to provide the long-life organic light-emitting device.

As described in features (1) and(2), each of the first host and the second host has any of the structures represented by formulae [1] to [6], in which each of the structures is a structure whose carbon atoms are SP² carbon atoms only and is a molecular structure with high bond stability. That is, the compound has good chemical stability as a molecule, good sublimability, and good stability in the form of a film and thus can be suitably used for the organic light-emitting device.

Furthermore, a device configuration that meets the following requirements can be used because a longer-life organic light-emitting device, especially a white organic light-emitting device, can be provided.
(3) The first guest emits red fluorescence.
(4) The first guest is a hydrocarbon compound whose carbon atoms are SP² carbon atoms only and can further have a partial structure represented by any of formulae [7] to [10].
(5) The first light-emitting layer has a thickness equal to or larger than the second light-emitting layer.
(6) The second guest can be a material, such as a blue fluorescent material, having a light emission range that lies at shorter wavelengths than the first guest. Moreover, the concentration of the second guest in the second light-emitting layer can be 1.0% or more by mass and 3.0% or less by mass.
(7) A third guest that fluoresces, for example, a green fluorescent material, can be contained.
(8) Each of the first guest, the second guest, and the third guest has a partial structure containing two or more fluoranthene skeletons.
(9) The second guest does not contain an electron-withdrawing substituent or an electron-donating substituent.

These will be described below.
(3) The first guest emits red fluorescence.

As described in features (1) and (2) above, each of the first host and the second host is the hydrocarbon compound whose carbon atoms are SP² carbon atoms only. This results in high electron mobility, which is advantageous for low-voltage driving. Meanwhile, electrons may easily reach the electron-blocking layer (EBL) through the first light-emitting layer and the second light-emitting layer. The arrival of electrons at EBL may cause carrier leakage and thus may deteriorate the efficiency. EBL typically contains an amine compound. The arrived electrons may cause the deterioration of the amine compound; thus, the arrival of electrons may decrease the life.

For these reasons, the first light-emitting layer located adjacent to the anode can contain a first guest that emits red fluorescence. The red fluorescent material has a narrow band gap; thus, the electron-trapping properties due to the gap difference between the host and the guest are improved. This makes it easier for electrons to be trapped in the first light-emitting layer, so that it is possible to suppress a decrease in efficiency due to electron leakage and a deterioration in durability due to the deterioration of EBL.

When a red guest is contained in the second light-emitting layer adjacent to the cathode, the deterioration of the EBL due to electron trapping can be similarly suppressed. However, when the red guest is contained in the first light-emitting layer adjacent to the anode, the supply of electrons to the first light-emitting layer is not inhibited, and light emission originating from the first light-emitting layer can be obtained.
(4) The first guest is a hydrocarbon compound whose carbon atoms are SP² carbon atoms only and can further have a partial structure represented by any of formulae [7] to [10].

Similar to the first host and the second host, the first guest can also be a hydrocarbon compound that has high bond stability and whose carbon atoms are SP² carbon atoms only, as described in feature (1) above. From the viewpoint of compound stability, those substituents may contain no SP³ carbon atoms.

Each of the first host and the first guest is a compound whose carbon atoms are SP² carbon atoms only. This results in improved compatibility between the host and the guest. They can be used in combination from the viewpoint of the formation of the light-emitting layer of the organic light-emitting device. Here, the compatibility is described. For example, if the first guest has an SP³ carbon atom that is hydrophobic, the hydrophobic moieties may easily aggregate with each other. In other words, the first guest molecules may easily aggregate with each other, and the host and the guest may be easily separated. In this case, the light-emitting layer may have a nonuniform guest concentration to cause a nonuniform distribution of carriers and excitons in the light-emitting layer. The host and the guest having high compatibility with each other can be sufficiently mixed together to form a uniform light-emitting layer and can be used for the organic light-emitting device.

Here, a fluorescent material composed of a hydrocarbon exhibits fluorescence originating from a π-π* transition. For this reason, in order to exhibit a light emission range in the red region, the conjugation length of the molecular skeleton can be extended, for example, as illustrated in [a] and [b] below. Fluoranthene illustrated in [a] below emits light in the blue region, whereas diindeno[1,2,3-cd:1',2',3'-lm]perylene illustrated in [b] below emits light in the red region. This is due to the extension of the conjugation length.

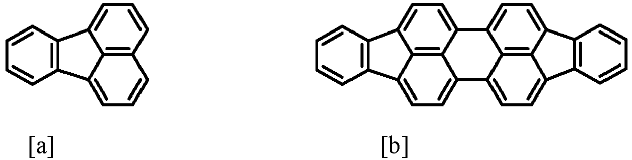

Meanwhile, an increase in conjugation length may lead to molecular aggregation derived from the π-π stacking. The molecular aggregation may lead to a deterioration in sublimability and a decrease in efficiency due to concentration quenching. To suppress the molecular aggregation, the first guest can have a partial structure represented by any of the following formulae [7] to [10]. In formulae [7] to [10], each * represents the binding position with a carbon atom, such as an SP² carbon atom.

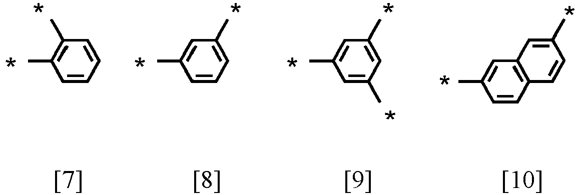

Table 4 presents the results of comparisons in sublimability between exemplified compound RD21 serving as the first guest and compound 1 and between exemplary compound RD30 serving as the first guest and compound 2. As an evaluation of sublimability, comparisons are made of the temperature difference between the sublimation temperature and the decomposition temperature (ΔT = decomposition temperature - sublimation temperature). A larger temperature difference can be said to indicate higher sublimability. With regard to the decomposition temperature, TG/DTA measurement was performed, and the temperature at which a reduction in mass reached 5% was defined as the decomposition temperature. With regard to the sublimation temperature, the sublimation purification was performed by slowly increasing the temperature while allowing Ar to flow at a degree of vacuum of 1 × 10⁻¹ Pa, and the temperature at which a sufficient sublimation rate was reached was defined as the sublimation temperature.

**Table 4**

| | Structure | ΔT = decomposition temperature - sublimation temperature |
|---|---|---|
| Exemplified compound RD21 | 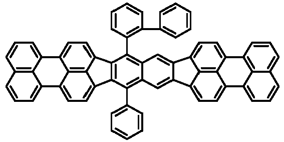 | 100 |
| Compound 1 | 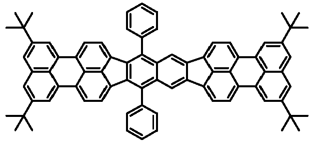 | 40 |
| Exemplified compound RD30 | 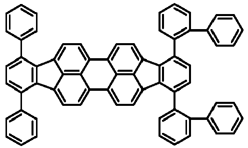 | 130 |
| Compound 2 | 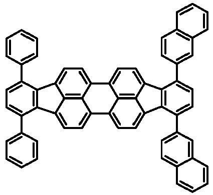 | 60 |

Table 4 indicates that ΔT of exemplified compound RD21 is 100°C, whereas ΔT of compound 1 is 40°C. That is, exemplified compound RD21 can be said to have higher sublimability. Table 4 also indicates that ΔT of exemplified compound RD30 is 130°C, whereas ΔT of compound 2 is 60°C. That is, exemplified compound RD30 can be said to have higher sublimability.

Exemplified compound RD21 and compound 1 both have a basic skeleton illustrated in [c] below, and exemplified compound RD30 and compound 2 both have a basic skeleton illustrated in [d] below.

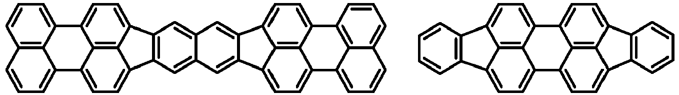

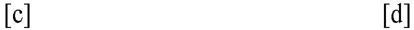

The structural difference between exemplified compound RD21 and compound 1 and between exemplified compound RD30 and compound 2 is the presence or absence of any of the partial structures represented by formulae [7] to [10]. That is, exemplified compound RD21 has a partial structure represented by formula [7], whereas compound 1 does not have any of the partial structures represented by formulas [7] to [10]. Exemplified compound RD29 has a partial structure represented by formula [7], whereas compound 2 does not have any of the partial structures represented by formulae [7] to [10]. That is, the presence of any of the partial structures represented by formulae [7] to [10] is considered to improve the sublimability.
(5) The first light-emitting layer has a thickness equal to or larger than the second light-emitting layer.

As described in feature (3) above, the first light-emitting layer traps electrons and plays a role in suppressing electron leakage to the electron-blocking layer (EBL). Moreover, the first light-emitting layer having a thickness equal to or larger than the second light-emitting layer can reduce the number of electrons reaching EBL and can be used. This can provide the organic light-emitting device having superior durability characteristics.
(6) The second guest can be a material, such as a blue fluorescent material, having a light emission range that lies at shorter wavelengths than the first guest. Moreover, the concentration of the second guest in the second light-emitting layer can be 1.0% or more by mass and 3.0% or less by mass.

The second guest can be a material having a light emission range that lies at shorter wavelengths than the first guest, and can be a blue-light-emitting material. In the case where light emission in the red region is obtained from the first light-emitting layer and where light emission in the blue region is obtained from the second light-emitting layer, a white organic light-emitting device is obtained as a result. The second guest can be a hydrocarbon compound because it is less likely to cleave bonds during the driving of the device and improves the driving durability of the device.

As described in feature (1), the second host is the compound whose carbon atoms are SP² carbon atoms only and thus has high electron mobility. When the second guest is a blue light-emitting material, a difficulty may lie in imparting sufficient electron-trapping properties to the second light-emitting layer due to the large band gap. This may make it difficult to obtain blue light emitted from the second light-emitting layer. This is because the electron-trapping properties are based on carrier trapping due to a difference in LUMO level between the host and the guest. The inventors have found that the concentration of the second guest in the second light-emitting layer can be 1.0% or more by mass and 3.0% or less by mass when the mass of the second light-emitting layer is defined as 100% by mass.

An extremely low concentration of the second guest may fail to sufficiently trap electrons due to a small density of traps generated inside the second light-emitting layer and thus may fail to provide sufficient light emission from the second light-emitting layer. An excessively high concentration of the second guest may cause the second guest molecules to aggregate with each other, leading to a decrease in efficiency due to concentration quenching.

The inventors have conducted intensive studies and have found that the concentration of the second guest can be sufficiently high and specifically, can be 1.0% or more by mass and 3.0% or less by mass. Details will be described in Examples. (7) A third guest that fluoresces, for example, a green fluorescent material, can be contained.

The white organic light-emitting device can contain a green fluorescent material as a third guest.

This is because, in reproducing white color, a white organic light-emitting device that emits three primary colors of blue, green, and red loses less energy and consumes less electric power than a white organic light-emitting device that emits two colors, such as cyan and yellow, as described in U.S. Patent Application Publication No. 2004/0241491. The third guest can be a hydrocarbon compound because the bond is not easily cleaved during the driving of the device to result in improved driving durability of the device.

The third guest may be contained in the first light-emitting layer or the second light-emitting layer. Alternatively, a third light-emitting layer may be formed between the first light-emitting layer and the second light-emitting layer and may contain a third host and a third guest. In this case, the third host can have the same structural features as the first host and the second host. The third guest can be contained in the first light-emitting layer. Such a device configuration should provide the effect of reducing the power consumption of the white organic light-emitting device.
(8) Each of the first guest, the second guest, and the third guest has a partial structure containing two or more fluoranthene skeletons.

As described in feature (1) above, each of the first host and the second host is the compound whose carbon atoms are SP² carbon atoms only, and thus has high electron mobility. Thus, in order to impart sufficient electron-trapping properties to each light-emitting layer, the guest contained in each light-emitting layer can have a partial structure containing two or more fluoranthene skeletons. The reason for this is that the guest has the fluoranthene skeleton containing an electron-deficient five-membered ring and thus has a lower energy level of the lowest unoccupied molecular orbital (LUMO) (farther from the vacuum level). This can result in a larger difference in LUMO energy level between the guest and the host material to improve the electron-trapping properties. Moreover, the presence of two or more fluoranthene skeletons can result in enhanced electron-trapping properties. Accordingly, the number of electrons reaching EBL can be reduced, thereby providing the organic light-emitting device with superior durability characteristics.

Specific examples of the partial structure containing two or more fluoranthene skeletons are illustrated below. However, these partial structures are only specific examples, and are not limited thereto. The fluoranthene skeletons may be condensed with each other. For example, like FF1, the benzene rings constituting the fluoranthene skeletons may form a condensed ring. For example, like FF8, benzene rings other than the benzene rings constituting the fluoranthene skeletons may form a condensed ring. For example, like FF17, benzene rings constituting the fluoranthene skeletons may be taken together to form a condensed ring. The fluoranthene skeletons may share a benzene ring constituting the fluoranthene skeleton, such as FF5 and FF11. 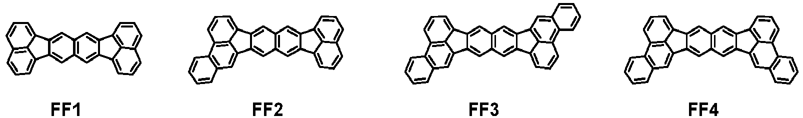 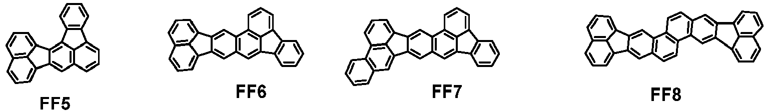 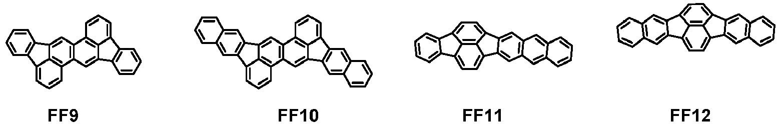 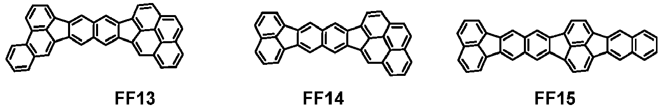 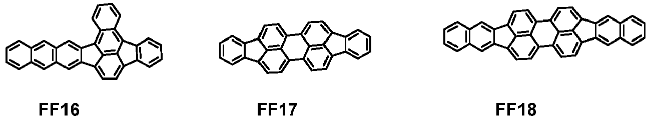 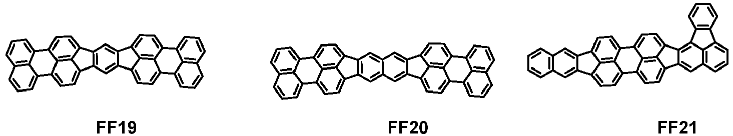 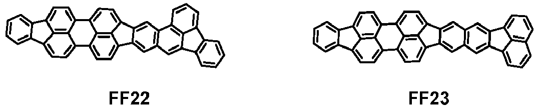 (9) The second guest does not contain an electron-withdrawing substituent or an electron-donating substituent.

When the second guest is a blue fluorescent material, the second guest is a material with the highest energy among the guests.

Thus, the excited state is a high-energy state, an unexpected side reaction may occur in the excited state. Accordingly, the second guest may contain no electron-withdrawing substituent or electron-donating substituent. When the second guest does not contain an electron-withdrawing substituent or an electron-donating substituent, addition reactions with neighboring molecules and bond dissociation of the molecules themselves can be reduced under high energy in the excited state. For the same reason, the third guest may also contain no electron-withdrawing substituent or electron-donating substituent.

Examples of the electron-withdrawing substituent include halogen atoms, such as fluorine atoms and chlorine atoms, heterocycles each containing an electron-deficient nitrogen atom, such as a pyridine ring and a triazine ring, and a cyano group. Examples of the electron-donating substituent include substituents each containing an electron-donating nitrogen atom, such as diphenylamine and carbazole, and substituents each containing an electron-donating oxygen atom, such as a methoxy group and a phenoxy group. The use of the guest free of these substituents allows electrophilic and nucleophilic reactions to be less likely to occur in the excited state to improve chemical stability, thereby providing the organic light-emitting device with superior durability characteristics.

As described above, the organic light-emitting device having superior durability characteristics can be obtained by using the first host and the second host that are each a hydrocarbon compound whose carbon atoms are SP² carbon atoms only and which has any of the structures represented by formulae [1] to [6], using the guest having the molecular structure that can be used for the light-emitting layers, and selecting the device configuration.

### Specific Examples

Specific examples of the first host and the second host are illustrated below. However, these compounds are merely specific examples, and the first host and the second host are not limited thereto.

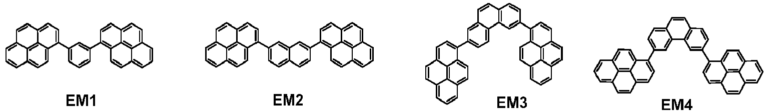

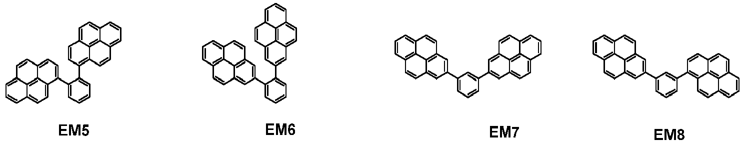

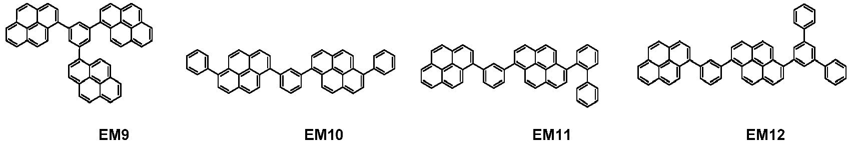

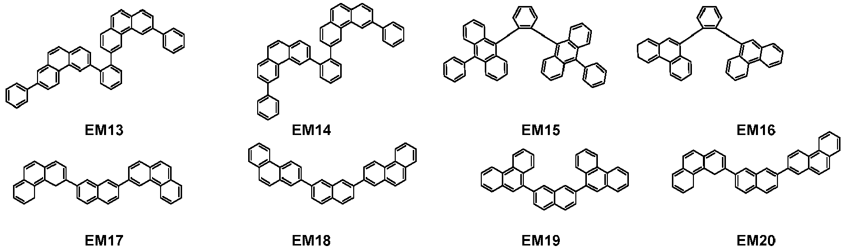

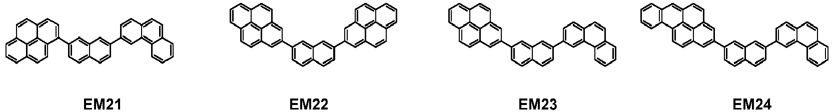

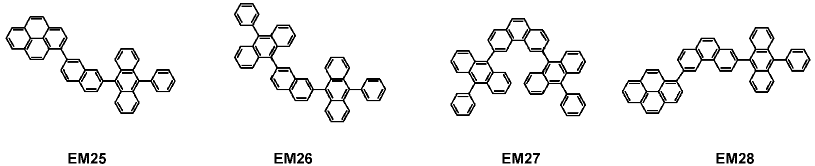

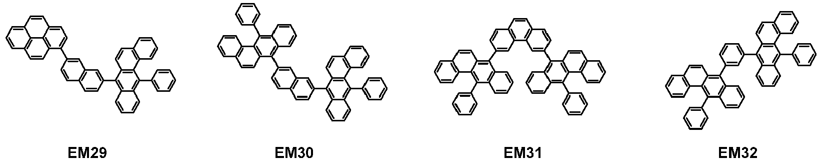

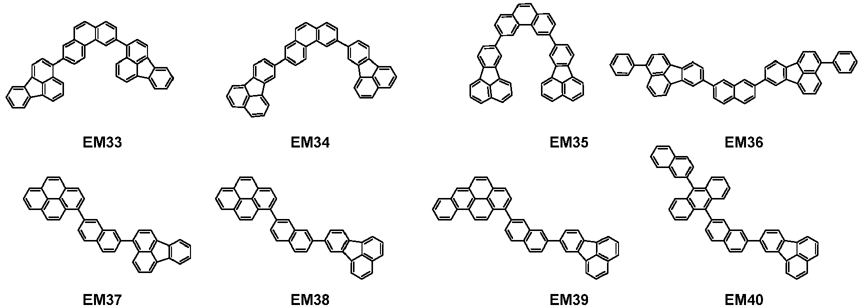

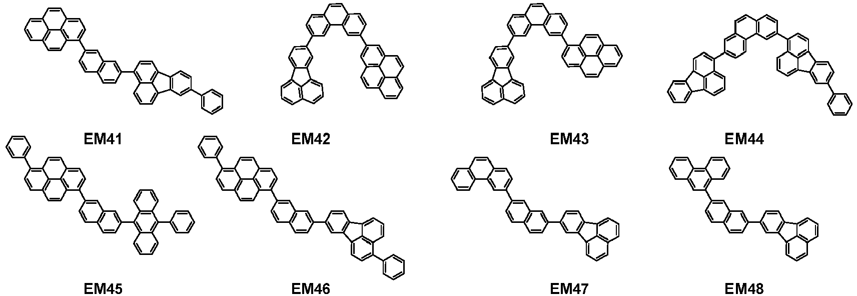

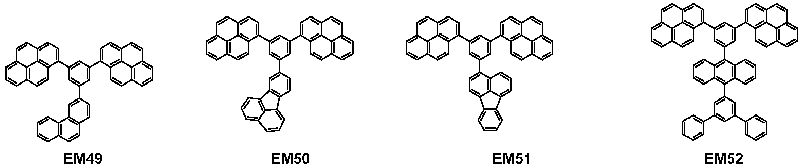

Specific examples of the first guest are illustrated below. However, these compounds are merely specific examples, and the first guest is not limited thereto.

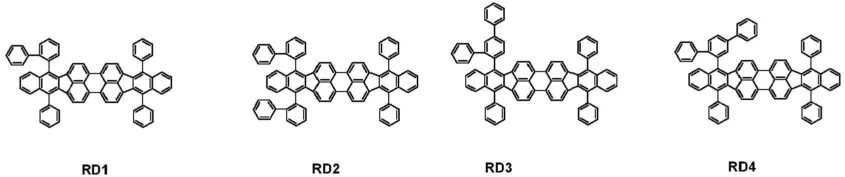

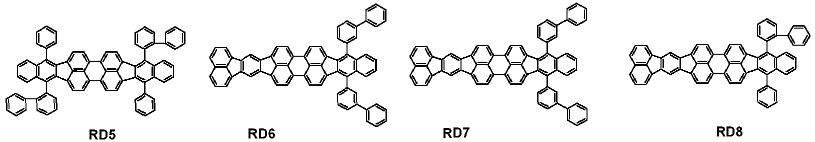

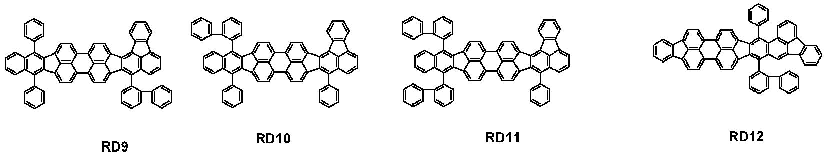

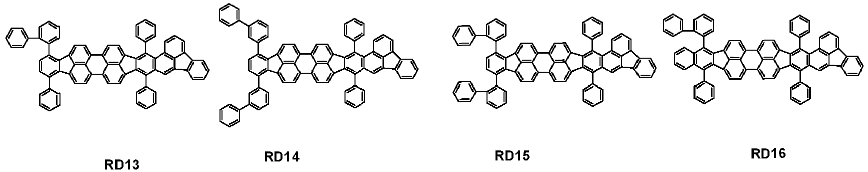

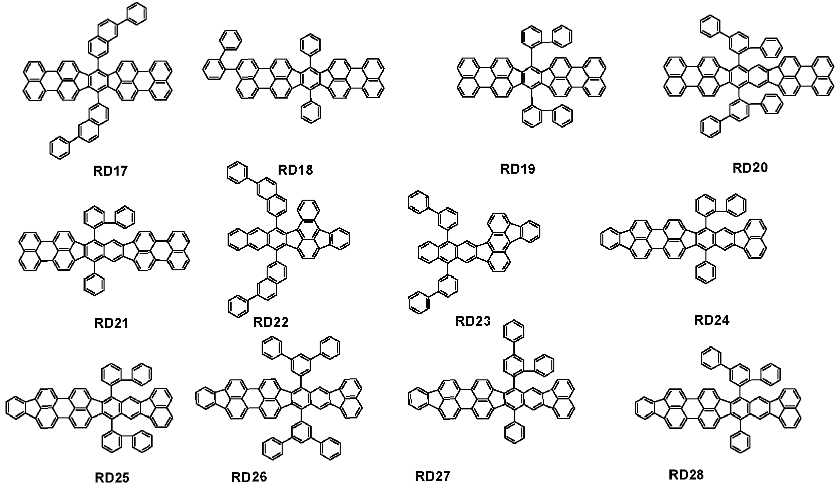

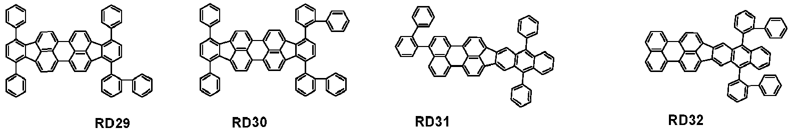

In the first guest group, RD1 to RD30, each having a partial structure containing two or more fluoranthene skeletons, can be used.

Specific examples of the second guest are illustrated below. However, these compounds are merely specific examples, and second guest is not limited thereto.

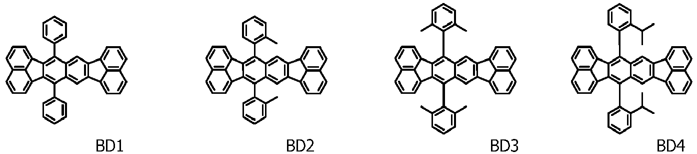

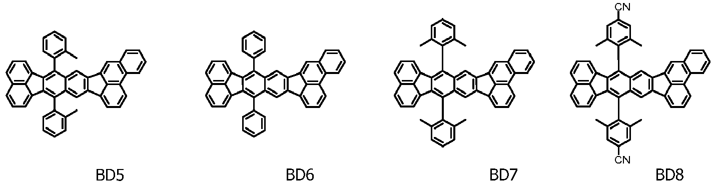

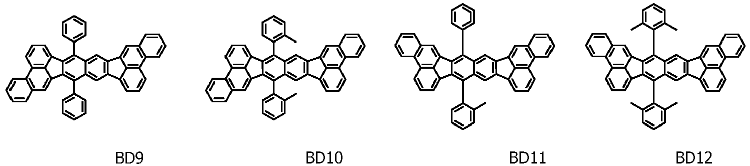

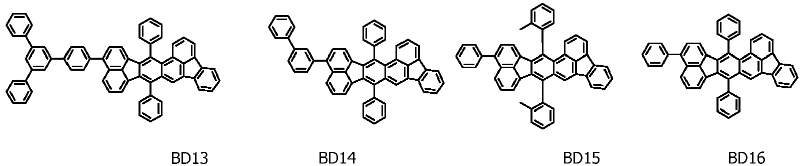

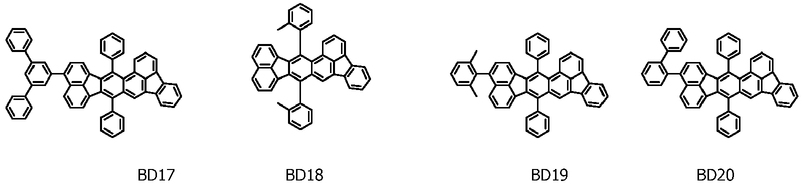

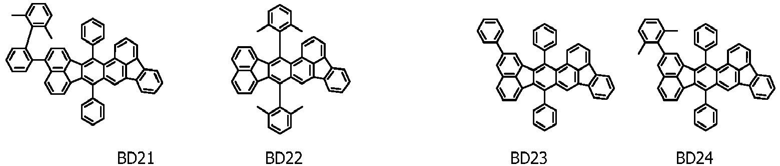

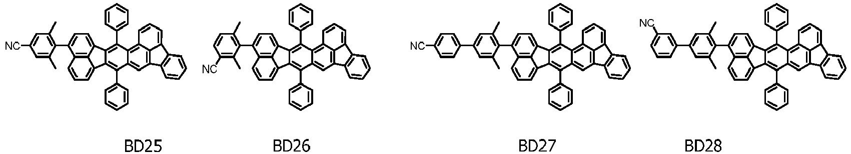

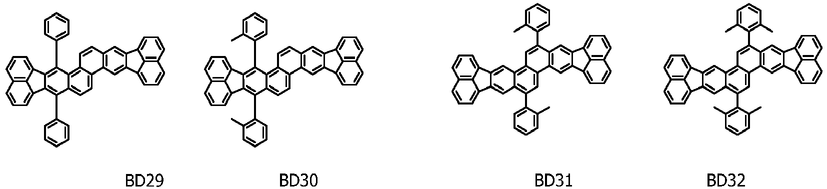

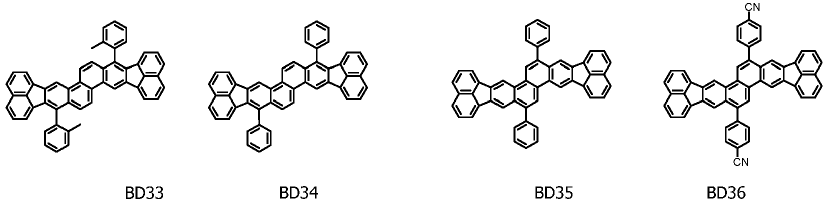

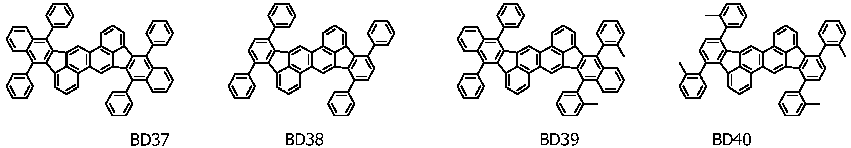

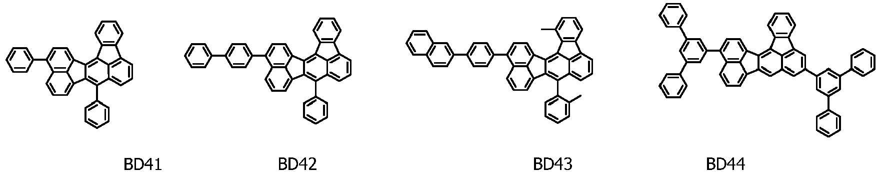

In the second guest group, BD1 to BD7, BD9 to BD24, BD29 to BD35, and BD37 to BD44, which contain no electron-withdrawing substituent, can be used.

Specific examples of the third guest are illustrated below. However, these compounds are merely specific examples, and the third guest is not limited thereto.

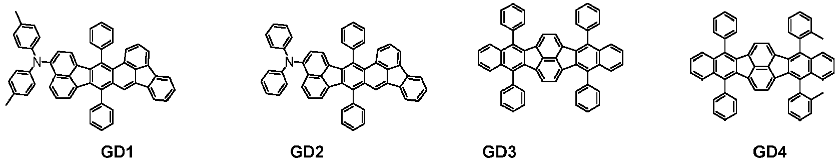

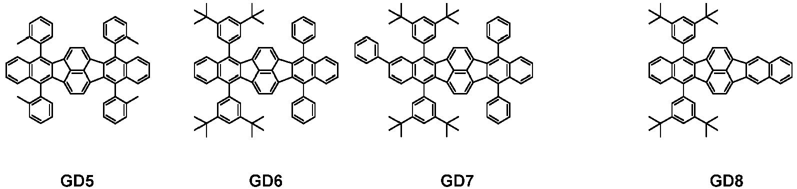

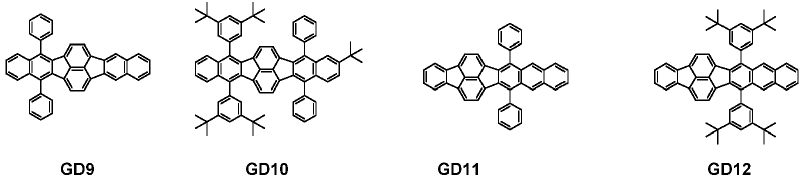

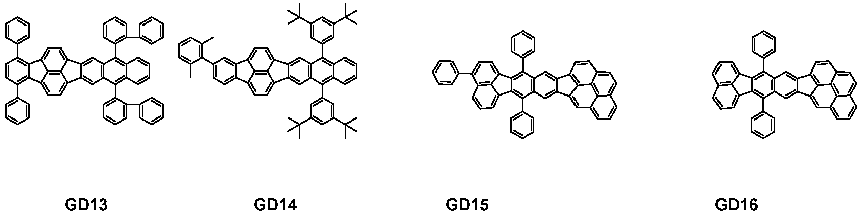

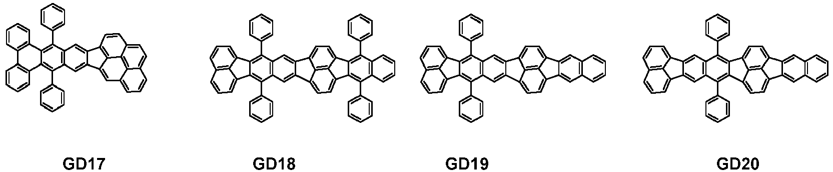

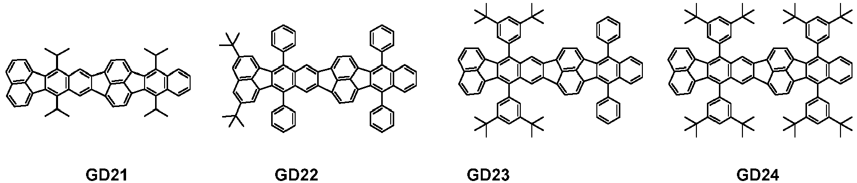

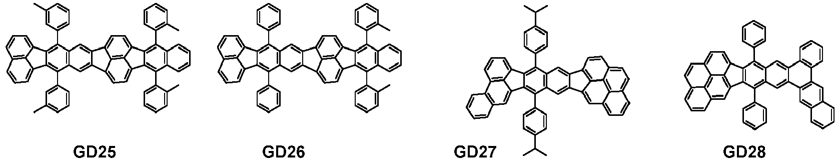

In the third guest group, GD1 to GD5, GD9, GD11, GD13, GD15 to GD21, and GD25 to GD28, which contain no tert-butyl group, can be used. This is because these guests containing no tert-butyl group is less likely to generate radicals.

### Hole Injection-Transport Material and Electron Transport Material

In the organic light-emitting device according to the present embodiment, a known low- or high-molecular-weight hole injection compound, hole transport compound, electron injection compound, or electron-transport compound may be used together, as needed. Examples of these compounds are illustrated below.

As a hole injection-transport material, a material having a high hole mobility can be used so as to facilitate the injection of holes from the anode and to transport the injected holes to the light-emitting layer. To suppress a deterioration in film quality, such as crystallization, in the organic light-emitting device, a material having a high glass transition temperature can be used. Examples of a low- or high-molecular-weight material having the ability to inject and transport holes include triarylamine derivatives, aryl carbazole derivatives, phenylenediamine derivatives, stilbene derivatives, phthalocyanine derivatives, porphyrin derivatives, poly(vinyl carbazole), polythiophene, and other conductive polymers. Moreover, the hole injection-transport material can also be used for the electron-blocking layer. Non-limiting specific examples of a compound used as the hole injection-transport material will be illustrated below.

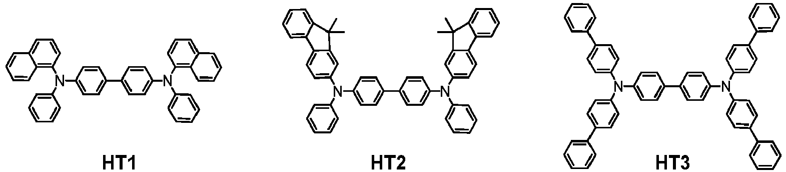

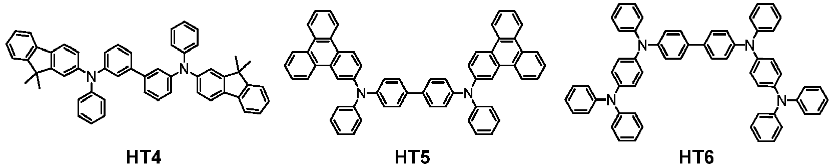

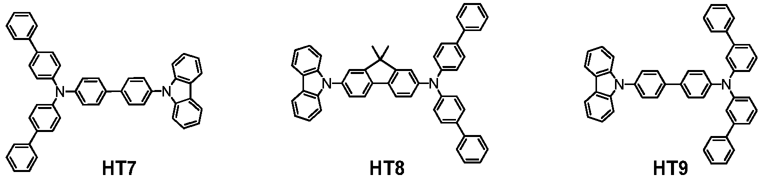

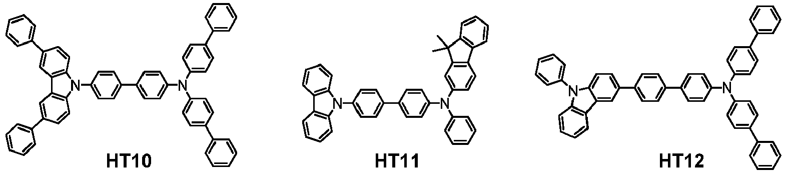

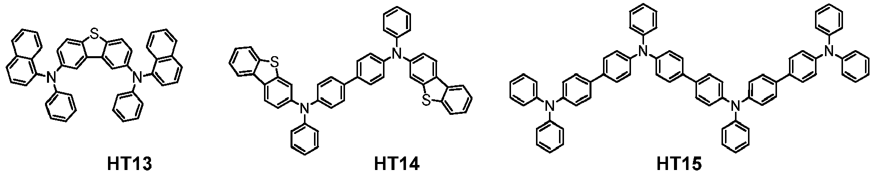

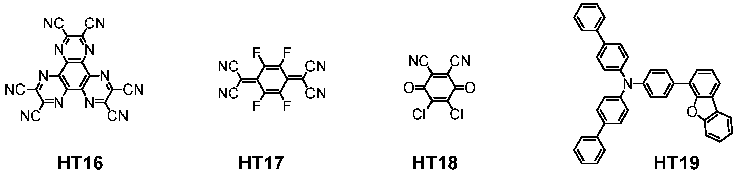

The electron transport material can be freely-selected from materials capable of transporting electrons injected from the cathode to the light-emitting layer and is selected in consideration of, for example, the balance with the hole mobility of the hole transport material. The electron transport material can be a compound that has low linearity and easily suppress molecular aggregation because good film properties are provided to improve the driving durability of the device. Examples of a material having the ability to transport electrons include oxadiazole derivatives, oxazole derivatives, pyrazine derivatives, triazole derivatives, triazine derivatives, quinoline derivatives, quinoxaline derivatives, phenanthroline derivatives, organoaluminum complexes, and fused-ring compounds, such as fluorene derivatives, naphthalene derivatives, chrysene derivatives, and anthracene derivatives. The electron transport materials can be used for the hole-blocking layer. Non-limiting specific examples of a compound used as the electron transport material will be illustrated below.

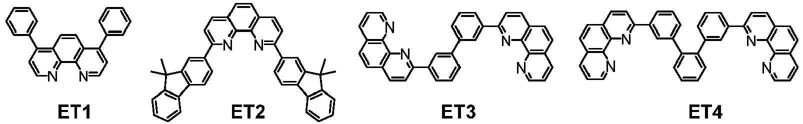

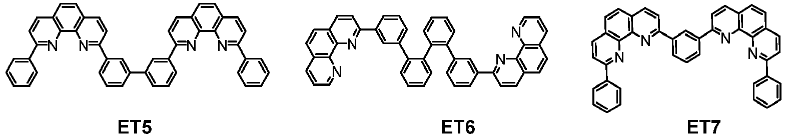

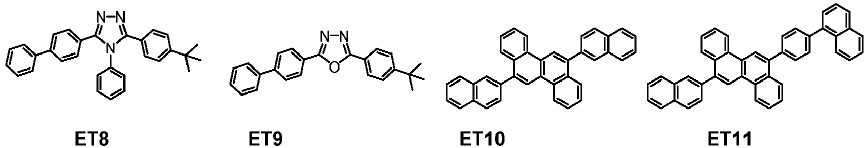

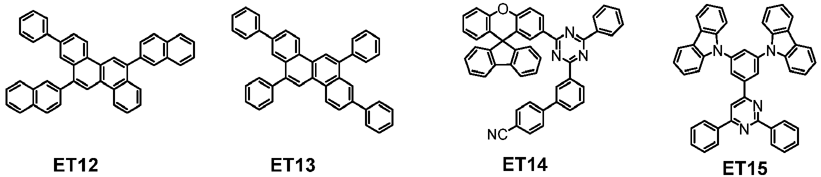

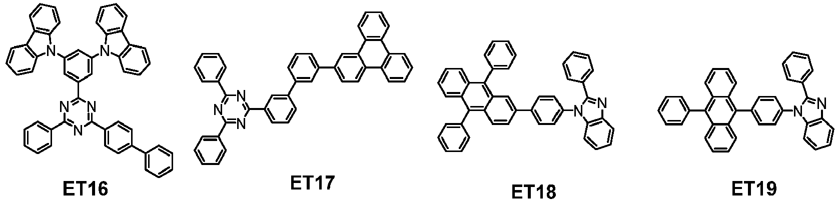

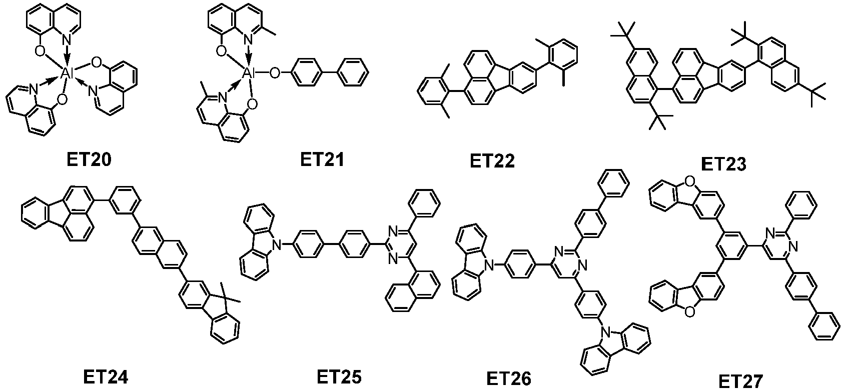

### Configuration of Organic Light-Emitting Device

The organic light-emitting device includes an insulating layer, a first electrode, an organic compound layer, a second electrode over a substrate. A protective layer, a color filter, a microlens may be disposed over the second electrode. In the case of disposing the color filter, a planarization layer may be disposed between the protective layer and the color filter. The planarization layer can be composed of, for example, an acrylic resin. The same applies when a planarization layer is provided between the color filter and the microlens.

### Substrate

Examples of the substrate include silicon wafers, quartz substrates, glass substrates, resin substrates, and metal substrates. The substrate may include a switching element, such as a transistor, a line, and an insulating layer thereon. Any material can be used for the insulating layer as long as a contact hole can be formed in such a manner that a line can be coupled to the first electrode and as long as insulation with a non-connected line can be ensured. For example, a resin, such as polyimide, silicon oxide, or silicon nitride, can be used.

### Electrode

A pair of electrodes can be used. The pair of electrodes may be an anode and a cathode.

When an electric field is applied in the direction in which the organic light-emitting device emits light, an electrode having a higher potential is the anode, and the other is the cathode. It can also be said that the electrode that supplies holes to the light-emitting layer is the anode and that the electrode that supplies electrons is the cathode.

As the component material of the anode, a material having a work function as high as possible can be used. Examples of the material that can be used include elemental metals, such as gold, platinum, silver, copper, nickel, palladium, cobalt, selenium, vanadium, and tungsten, mixtures thereof, alloys of combinations thereof, and metal oxides, such as tin oxide, zinc oxide, indium oxide, indium-tin oxide (ITO), and indium-zinc oxide. Additionally, conductive polymers, such as polyaniline, polypyrrole, and polythiophene, can be used.

These electrode materials may be used alone or in combination of two or more. The anode may be formed of a single layer or multiple layers.

When the anode is used as a reflective electrode, for example, chromium, aluminum, silver, titanium, tungsten, molybdenum, an alloy thereof, or a stack thereof can be used. These materials can also be used to act as a reflective film that does not have the role of an electrode. When the anode is used as a transparent electrode, a transparent conductive oxide layer composed of, for example, indium-tin oxide (ITO) or indium-zinc oxide can be used; however, the anode is not limited thereto.

The electrode can be formed by photolithography.

As the component material of the cathode, a material having a lower work function can be used. Examples thereof include elemental metals such as alkali metals, e.g., lithium, alkaline-earth metals, e.g., calcium, aluminum, titanium, manganese, silver, lead, and chromium, and mixtures thereof. Alloys of combinations of these elemental metals can also be used. For example, magnesium-silver, aluminum-lithium, aluminum-magnesium, silver-copper, and zinc-silver can be used. Metal oxides, such as indium-tin oxide (ITO), can also be used. These electrode materials may be used alone or in combination of two or more. The cathode may have a single-layer structure or a multilayer structure. In particular, silver can be used. To reduce the aggregation of silver, a silver alloy can be used. Any alloy ratio may be used as long as the aggregation of silver can be reduced. The ratio of silver to another metal may be, for example, 1:1 or 3:1.

A top emission device may be provided using the cathode formed of a conductive oxide layer composed of, for example, ITO. A bottom emission device may be provided using the cathode formed of a reflective electrode composed of, for example, aluminum (Al). Any type of cathode may be used. Any method for forming the cathode may be employed. For example, a direct-current or alternating-current sputtering technique can be employed because good film coverage is obtained and thus the resistance is easily reduced.

### Organic Compound Layer

The organic compound layer may include a layer other than the light-emitting layer. The layer other than the light-emitting layer may be formed of a single layer or multiple layers. When multiple layers are present, they may be referred to as a hole injection layer, a hole transport layer, an electron-blocking layer, a hole-blocking layer, an electron transport layer, or an electron injection layer in accordance with their functions. The organic compound layer is mainly composed of an organic compound, and may contain inorganic atoms and an inorganic compound. For example, the organic compound layer may contain, for example, copper, lithium, magnesium, aluminum, iridium, platinum, molybdenum, or zinc. The organic compound layer may be disposed between the first electrode and the second electrode, and may be disposed in contact with the first electrode and the second electrode.

The organic compound layer, such as the hole injection layer, the hole transport layer, the electron-blocking layer, the light-emitting layer, the hole-blocking layer, the electron transport layer, or the electron injection layer, included in the organic light-emitting device according to an embodiment of the present disclosure is formed by a method described below.

For the organic compound layer included in the organic light-emitting device according to an embodiment of the present disclosure, a dry process, such as a vacuum evaporation method, an ionized evaporation method, sputtering, or plasma, may be employed. Alternatively, instead of the dry process, it is also possible to employ a wet process in which a material is dissolved in an appropriate solvent and then a film is formed by a known coating method, such as spin coating, dipping, a casting method, a Langmuir-Blodgett (LB) technique, or an inkjet method.

When the layer is formed by, for example, the vacuum evaporation method or the solution coating method, crystallization and so forth are less likely to occur, and good stability with time is obtained. In the case of forming a film by the coating method, the film may be formed in combination with an appropriate binder resin.

Non-limiting examples of the binder resin include poly(vinyl carbazole) resins, polycarbonate resins, polyester resins, acrylonitrile butadiene styrene (ABS) resins, acrylic resins, polyimide resins, phenolic resins, epoxy resins, silicone resins, and urea resins.

These binder resins may be used alone as a homopolymer or copolymer or in combination as a mixture of two or more. Furthermore, additives, such as a known plasticizer, antioxidant, and ultraviolet absorber, may be used, as needed.

### Protective Layer

A protective layer may be disposed on the second electrode. For example, a glass member provided with a moisture absorbent can be bonded to the second electrode to reduce the entry of, for example, water into the organic compound layer, thereby reducing the occurrence of display defects. In another embodiment, a passivation film composed of, for example, silicon nitride may be disposed on the second electrode to reduce the entry of, for example, water into the organic compound layer. For example, after the formation of the second electrode, the substrate may be transported to another chamber without breaking the vacuum, and a silicon nitride film having a thickness of 2 µm may be formed by a chemical vapor deposition (CVD) method to provide a protective layer. After the film deposition by the CVD method, a protective layer may be formed by an atomic layer deposition (ALD) method. Non-limiting examples of the material of the layer formed by the ALD method may include silicon nitride, silicon oxide, and aluminum oxide. Silicon nitride may be deposited by the CVD method on the layer formed by the ALD method. The film formed by the ALD method may have a smaller thickness than the film formed by the CVD method. Specifically, the thickness may be 50% or less, even 10% or less.

### Color Filter

A color filter may be disposed on the protective layer. For example, a color filter may be disposed on another substrate in consideration of the size of the organic light-emitting device and bonded to the substrate provided with the organic light-emitting device. A color filter may be formed by patterning on the protective layer using photolithography. The color filter may be composed of a polymer.

### Planarization Layer

A planarization layer may be disposed between the color filter and the protective layer. The planarization layer is provided for the purpose of reducing the unevenness of the layer underneath. The planarization layer may be referred to as a "material resin layer" without limiting its purpose. The planarization layer may be composed of an organic compound. A low- or high-molecular-weight organic compound may be used. A high-molecular-weight organic compound can be used.

The planarization layers may be disposed above and below (or on) the color filter and may be composed of the same or different component materials. Specific examples thereof include poly(vinyl carbazole) resins, polycarbonate resins, polyester resins, acrylonitrile butadiene styrene (ABS) resins, acrylic resins, polyimide resins, phenolic resins, epoxy resins, silicone resins, and urea resins.

### Microlens

The organic light-emitting device or an organic light-emitting apparatus may include an optical component, such as a microlens, on the outgoing light side. The microlens can be composed of, for example, an acrylic resin or an epoxy resin. The microlens may be used to increase the amount of light emitted from the organic light-emitting device or the organic light-emitting apparatus and to control the direction of the light emitted. The microlens may have a hemispherical shape. In the case of a hemispherical shape, among tangents to the hemisphere, there is a tangent parallel to the insulating layer. The point of contact of the tangent with the hemisphere is the vertex of the microlens. The vertex of the microlens can be determined in the same way for any cross-sectional view. That is, among the tangents to the semicircle of the microlens in the cross-sectional view, there is a tangent parallel to the insulating layer, and the point of contact of the tangent with the semicircle is the vertex of the microlens.

The midpoint of the microlens can be defined. In the cross section of the microlens, when a segment is hypothetically drawn from the point where an arc shape ends to the point where another arc shape ends, the midpoint of the segment can be referred to as the midpoint of the microlens. The cross section to determine the vertex and midpoint may be a cross section perpendicular to the insulating layer.

### Opposite Substrate

An opposite substrate may be disposed on the planarization layer. The opposite substrate is disposed at a position corresponding to the substrate described above and thus is called an opposite substrate. The opposite substrate may be composed of the same material as the substrate described above. When the above-described substrate is referred to as a first substrate, the opposite substrate may be referred to as a second substrate.

### Pixel Circuit

An organic light-emitting apparatus including organic light-emitting devices may include pixel circuits coupled to the organic light-emitting devices. Each of the pixel circuits may be of an active matrix type, which independently controls the emission of first and second light-emitting devices. The active matrix type circuit may be voltage programming or current programming. A driving circuit includes the pixel circuit for each pixel. The pixel circuit may include a light-emitting device, a transistor to control the luminance of the light-emitting device, a transistor to control the timing of the light emission, a capacitor to retain the gate voltage of the transistor to control the luminance, and a transistor to connect to GND without using the light-emitting device.

The light-emitting apparatus includes a display area and a peripheral area disposed around the display area. The display area includes a pixel circuit, and the peripheral area includes a display control circuit. The mobility of a transistor contained in the pixel circuit may be lower than the mobility of a transistor contained in the display control circuit.

The gradient of the current-voltage characteristics of the transistor contained in the pixel circuit may be smaller than the gradient of the current-voltage characteristic of the transistor contained in the display control circuit. The gradient of the current-voltage characteristics can be measured by what is called Vg-Ig characteristics. The transistor contained in the pixel circuit is a transistor coupled to a light-emitting device, such as a first light-emitting device.

### Pixel

An organic light-emitting apparatus including an organic light-emitting device may include multiple pixels. Each pixel includes subpixels configured to emit colors different from each other. The subpixels may have respective red, green, and blue (RGB) emission colors.

Light emerges from a region of the pixel, also called a pixel aperture. This region is the same as a first region. The pixel aperture may be 15 µm or less, and may be 5 µm or more. More specifically, the pixel aperture may be, for example, 11 µm, 9.5 µm, 7.4 µm, or 6.4 µm. The distance between subpixels may be 10 µm or less. Specifically, the distance may be 8 µm, 7.4 µm, or 6.4 µm.

The pixels may be arranged in a known pattern in plan view. For example, a stripe pattern, a delta pattern, a Pen Tile matrix pattern, or the Bayer pattern may be used. The shape of each subpixel in plan view may be any known shape. Examples of the shape of the subpixel include quadrilaterals, such as rectangles and rhombi, and hexagons. Of course, if the shape is close to a rectangle, rather than an exact shape, it is included in the rectangle. The shape of the subpixel and the pixel arrangement can be used in combination.

### Application of Organic Light-Emitting Device

The organic light-emitting device according to the present embodiment can be used as a component member of a display apparatus or lighting apparatus. Other applications include exposure light sources for electrophotographic image-forming apparatuses, backlights for liquid crystal displays, and light-emitting apparatuses including white-light sources and color filters.

The display apparatus may be an image information-processing unit having an image input unit that receives image information from an area or linear CCD sensor, a memory card, or any other source, an information-processing unit that processes the input information, and a display unit that displays the input image. The display apparatus includes multiple pixels, and at least one of the multiple pixels may include the organic light-emitting device according to the present embodiment and a transistor coupled to the organic light-emitting device.

The display unit of an image pickup apparatus or an inkjet printer may have a touch panel function. The driving mode of the touch panel function may be, but is not particularly limited to, an infrared mode, an electrostatic capacitance mode, a resistive film mode, or an electromagnetic inductive mode. The display apparatus may also be used for a display unit of a multifunction printer.

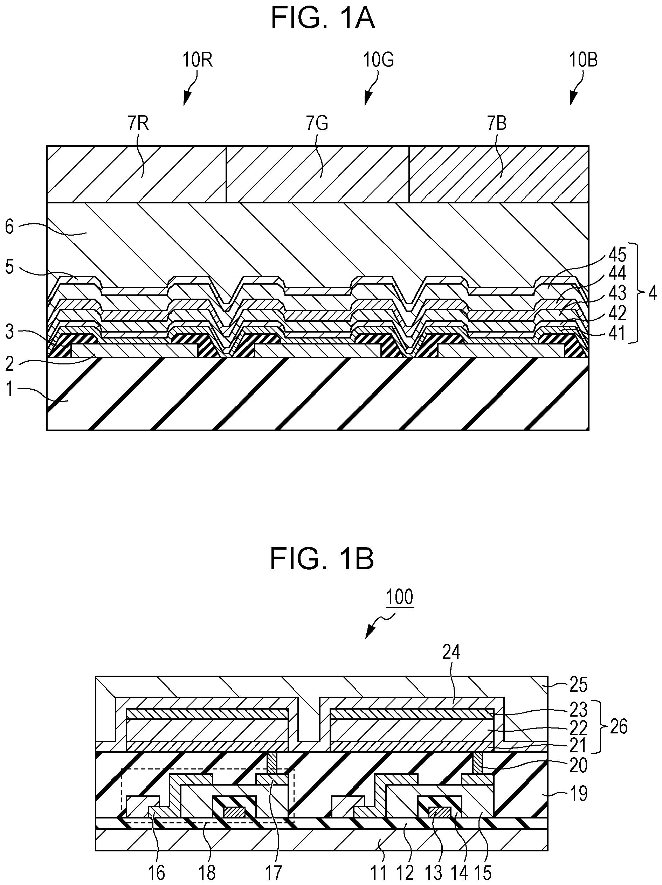

The following describes a display apparatus according to the present embodiment with reference to the attached drawings. Figs. 1A and 1B are each a schematic cross-sectional view of an example of a display apparatus including organic light-emitting devices and transistors coupled to the respective organic light-emitting devices. Each of the transistors is an example of an active element. The transistors may be thin-film transistors (TFTs).

Fig. 1A is an example of pixels that are components of the display apparatus according to the present embodiment. Each of the pixels includes subpixels 10. The subpixels are separated into 10R, 10G, and 10B according to their light emission. The emission color may be distinguished based on the wavelength of light emitted from the light-emitting layer. Alternatively, light emitted from the subpixels may be selectively transmitted or color-converted with, for example, a color filter. Each subpixels 10 includes a reflective electrode serving as a first electrode 2, an insulating layer 3 covering the edge of the first electrode 2, an organic compound layer 4 covering the first electrode 2 and the insulating layer 3, a transparent electrode serving as a second electrode 5, a protective layer 6, and a color filter 7 over an interlayer insulating layer 1.

The transistors and capacitive elements may be disposed under or in the interlayer insulating layer 1.

Each transistor may be electrically coupled to a corresponding one of the first electrodes 2 through a contact hole (not illustrated).

The insulating layer 3 is also called a bank or pixel separation film. The insulating layer 3 covers the edge of each first electrode 2 and surrounds the first electrode 2. Portions that are not covered with the insulating layer 3 are in contact with the organic compound layer 4 and serve as light-emitting regions.

The organic compound layer 4 includes a hole injection layer 41, a hole transport layer 42, a first light-emitting layer 43, a second light-emitting layer 44, and an electron transport layer 45.

The second electrode 5 may be a transparent electrode, a reflective electrode, or a semi-transparent electrode.

The protective layer 6 reduces the penetration of moisture into the organic compound layer 4. Although the protective layer 6 is illustrated as a single layer, the protective layer 6 may include multiple layers, and each layer may be an inorganic compound layer or an organic compound layer.

The color filter 7 is separated into 7R, 7G, and 7B according to its color. The color filter 7 may be disposed on a planarization film (not illustrated). A resin protective layer (not illustrated) may be disposed on the color filter 7. The color filter 7 may be disposed on the protective layer 6. Alternatively, the color filter 7 may be disposed on an opposite substrate, such as a glass substrate, and then bonded.

A display apparatus 100 illustrated in Fig. 1B includes organic light-emitting devices 26 and TFTs 18 as an example of transistors. A substrate 11 composed of a material, such as glass or silicon is provided, and an insulating layer 12 is disposed thereon. Active elements, such as the TFTs 18, are disposed on the insulating layer 12. The gate electrode 13, the gate insulating film 14, and the semiconductor layer 15 of each of the active elements are disposed thereon. Each TFT 18 further includes a drain electrode 16 and a source electrode 17. The TFTs 18 are overlaid with an insulating film 19. Anode 21 included in the organic light-emitting devices 26 is coupled to the source electrodes 17 through contact holes 20 provided in the insulating film 19.

The mode of electrical connection between the electrodes (anode 21 and cathode 23) included in each organic light-emitting device 26 and the electrodes (source electrode 17 and drain electrode 16) included in a corresponding one of the TFTs 18 is not limited to the mode illustrated in Fig. 1B. That is, it is sufficient that any one of the anode 21 and the cathode 23 is electrically coupled to any one of the source electrode 17 and the drain electrode 16 of the TFT 18. The term "TFT" refers to a thin-film transistor.

In the display apparatus 100 illustrated in Fig. 1B, although each organic compound layer 22 is illustrated as a single layer, the organic compound layer 22 may include multiple layers. To reduce the deterioration of the organic light-emitting devices 26, a first protective layer 24 and a second protective layer 25 are disposed on the cathodes 23.

In the display apparatus 100 illustrated in Fig. 1B, although the transistors are used as switching devices, other switching devices may be used instead.

The transistors used in the display apparatus 100 illustrated in Fig. 1B are not limited to transistors using a single-crystal silicon wafer, but may also be thin-film transistors including active layers on the insulating surface of a substrate. Examples of the material of the active layers include single-crystal silicon, non-single-crystal silicon, such as amorphous silicon and microcrystalline silicon; and non-single-crystal oxide semiconductors, such as indium zinc oxide and indium gallium zinc oxide. Thin-film transistors are also called TFT elements.

The transistors in the display apparatus 100 illustrated in Fig. 1B may be formed in the substrate, such as a Si substrate. The expression "formed in the substrate" indicates that the transistors are produced by processing the substrate, such as a Si substrate. In the case where the transistors are formed in the substrate, the substrate and the transistors can be deemed to be integrally formed.

In the organic light-emitting device according to the present embodiment, the luminance is controlled by the TFT devices, which are an example of switching devices; thus, an image can be displayed at respective luminance levels by arranging multiple organic light-emitting devices in the plane. The switching devices according to the present embodiment are not limited to the TFT devices and may be low-temperature polysilicon transistors or active-matrix drivers formed on a substrate such as a Si substrate. The expression "on a substrate" can also be said to be "in the substrate". Whether transistors are formed in the substrate or TFT devices are used is selected in accordance with the size of a display unit. For example, in the case where the display unit has a size of about 0.5 inches, organic light-emitting devices can be disposed on a Si substrate.

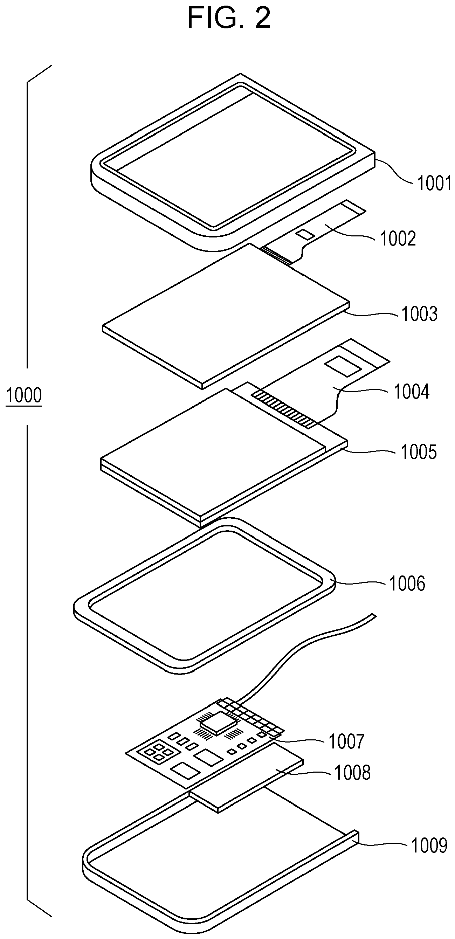

Fig. 2 is a schematic view illustrating an example of a display apparatus according to the present embodiment. A display apparatus 1000 may include a touch panel 1003, a display panel 1005, a frame 1006, a circuit substrate 1007, and a battery 1008 disposed between an upper cover 1001 and a lower cover 1009. The touch panel 1003 and the display panel 1005 are coupled to flexible printed circuits FPCs 1002 and 1004, respectively. The circuit substrate 1007 includes printed transistors. The battery 1008 need not be provided unless the display apparatus is a portable apparatus. The battery 1008 may be disposed at a different position even if the display apparatus is a portable apparatus.

The display apparatus according to the present embodiment may include a color filter having red, green, and blue portions. In the color filter, the red, green, and blue portions may be arranged in a delta arrangement.

The display apparatus according to the present embodiment may be used for the display unit of a portable terminal. In that case, the display apparatus may have both a display function and an operation function. Examples of the portable terminal include mobile phones such as smartphones, tablets, and head-mounted displays.

The display apparatus according to the present embodiment may be used for a display unit of an image pickup apparatus including an optical unit including multiple lenses and an image pickup device that receives light passing through the optical unit. The image pickup apparatus may include a display unit that displays information acquired by the image pickup device. The display unit may be a display unit exposed to the outside of the image pickup apparatus or a display unit disposed in a finder. The image pickup apparatus may be a digital camera or a digital camcorder.

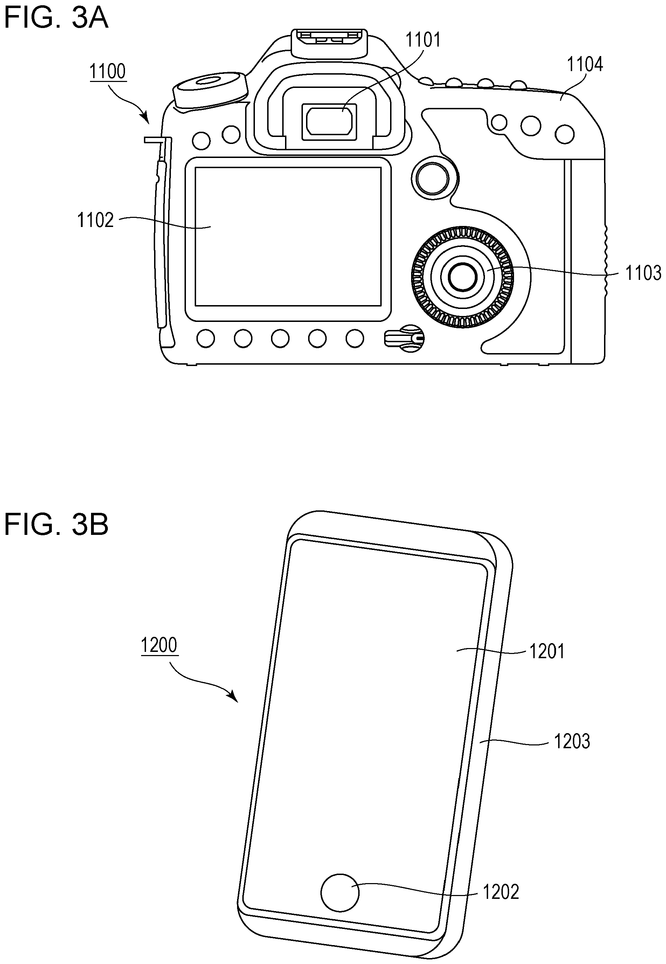

Fig. 3A is a schematic view illustrating an example of an image pickup apparatus according to the present embodiment. An image pickup apparatus 1100 may include a viewfinder 1101, a rear display 1102, an operation unit 1103, and a housing 1104. The viewfinder 1101 may include the display apparatus according to the present embodiment. In this case, the display apparatus may display environmental information, imaging instructions, and so forth in addition to an image to be captured. The environmental information may include, for example, the intensity of external light, the direction of external light, the moving speed of a subject, and the possibility that a subject is shielded by a shielding material.

The timing suitable for imaging is only for a short time; thus, the information may be displayed as soon as possible. The display apparatus including the organic light-emitting device according to the present disclosure can be used more suitably than liquid crystal displays because the organic light-emitting device has a fast response time. The display apparatus including the organic light-emitting device can be used more suitably than liquid crystal displays for such apparatuses required to have a high display speed.

The image pickup apparatus 1100 includes an optical unit (not illustrated). The optical unit includes multiple lenses and is configured to form an image on an image pickup device in the housing 1104. The relative positions of the multiple lenses can be adjusted to adjust the focal point. This operation can also be performed automatically. The image pickup apparatus may translate to a photoelectric conversion apparatus. Examples of an image capturing method employed in the photoelectric conversion apparatus may include a method for detecting a difference from the previous image and a method of cutting out an image from images always recorded, instead of sequentially capturing images.

Fig. 3B is a schematic view illustrating an example of an electronic apparatus according to the present embodiment. An electronic apparatus 1200 includes a display unit 1201, an operation unit 1202, and a housing 1203. The housing 1203 may accommodate a circuit, a printed circuit board including the circuit, a battery, and a communication unit. The operation unit 1202 may be a button or a touch-screen-type reactive unit. The operation unit 1202 may be a biometric recognition unit that recognizes a fingerprint to release the lock or the like. An electronic apparatus having a communication unit can also be referred to as a communication apparatus. The electronic apparatus 1200 may further have a camera function by being equipped with a lens and an image pickup device. An image captured by the camera function is displayed on the display unit 1201. Examples of the electronic apparatus 1200 include smartphones and notebook computers.

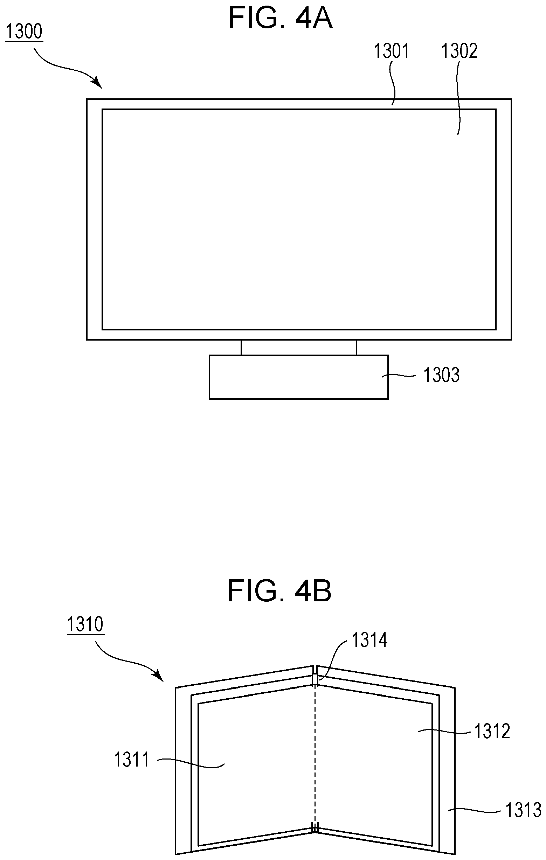

Fig. 4A is a schematic view illustrating an example of the display apparatus according to the present embodiment. Fig. 4A illustrates a display apparatus, such as a television monitor or a PC monitor. A display apparatus 1300 includes a frame 1301 and a display unit 1302. The light-emitting device according to the present embodiment may be used for the display unit 1302. The display apparatus 1300 includes a base 1303 that supports the frame 1301 and the display unit 1302. The base 1303 is not limited to the structure illustrated in Fig. 4A. The lower side of the frame 1301 may also serve as a base. The frame 1301 and the display unit 1302 may be curved. These may have a radius of curvature of 5,000 mm or more and 6,000 mm or less.

Fig. 4B is a schematic view illustrating another example of a display apparatus according to the present embodiment. A display apparatus 1310 illustrated in Fig. 4B can be folded and is what is called a foldable display apparatus. The display apparatus 1310 includes a first display portion 1311, a second display portion 1312, a housing 1313, and an inflection point 1314. The first display portion 1311 and the second display portion 1312 may include the light-emitting device according to the present embodiment. The first display portion 1311 and the second display portion 1312 may be a single, seamless display apparatus. The first display portion 1311 and the second display portion 1312 can be divided from each other at the inflection point. The first display portion 1311 and the second display portion 1312 may display different images. Alternatively, a single image may be displayed in the first and second display portions.

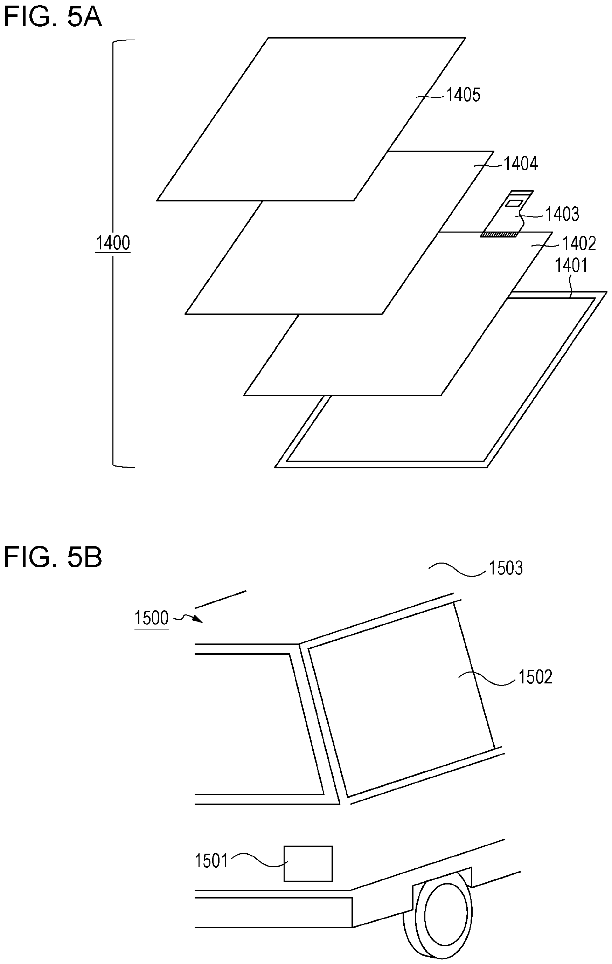

Fig. 5A is a schematic view illustrating an example of a lighting apparatus according to the present embodiment. A lighting apparatus 1400 may include a housing 1401, a light source 1402, a circuit board 1403, an optical filter 1404 that transmits light emitted from the light source 1402, and a light diffusion unit 1405. The light source 1402 may include an organic light-emitting device according to the present embodiment. The optical filter 1404 may be a filter that improves the color rendering properties of the light source. The light diffusion unit 1405 can effectively diffuse light from the light source to deliver the light to a wide range when used for illumination and so forth. The optical filter 1404 and the light diffusion unit 1405 may be disposed at the light emission side of the lighting apparatus. A cover may be disposed at the outermost portion, as needed.

The lighting apparatus is, for example, an apparatus that lights a room. The lighting apparatus may emit light of white, neutral white, or any color from blue to red. A light control circuit that controls the light may be provided.

The lighting apparatus may include the organic light-emitting device according to the present embodiment and a power supply circuit coupled thereto. The power supply circuit is a circuit that converts an AC voltage into a DC voltage. The color temperature of white is 4,200 K, and the color temperature of neutral white is 5,000 K. The lighting apparatus may include a color filter.

The lighting apparatus according to the present embodiment may include a heat dissipation unit. The heat dissipation unit is configured to release heat in the device to the outside of the device and is composed of, for example, a metal having a high specific heat and liquid silicone.

Fig. 5B is a schematic view illustrating an automobile as an example of a moving object according to the present embodiment. The automobile includes a tail lamp, which is an example of lighting units. An automobile 1500 includes a tail lamp 1501 and may be configured to light the tail lamp when a brake operation or the like is performed.

The tail lamp 1501 may include an organic light-emitting device according to the present embodiment. The tail lamp 1501 may include a protective member that protects the organic light-emitting device. The protective member may be composed of any transparent material having high strength to some extent and can be composed of, for example, polycarbonate. The polycarbonate may be mixed with, for example, a furandicarboxylic acid derivative or an acrylonitrile derivative.

The automobile 1500 may include an automobile body 1503 and windows 1502 attached thereto. The windows 1502 may be transparent displays if the windows are not used to check the front and back of the automobile. The transparent displays may include an organic light-emitting device according to the present embodiment.

In this case, the components, such as the electrodes, of the organic light-emitting device are formed of transparent members.

The moving object according to the present embodiment may be, for example, a ship, an aircraft, or a drone. The moving object may include a body and a lighting unit attached to the body. The lighting unit may emit light to indicate the position of the body. The lighting unit includes the organic light-emitting device according to the present embodiment.

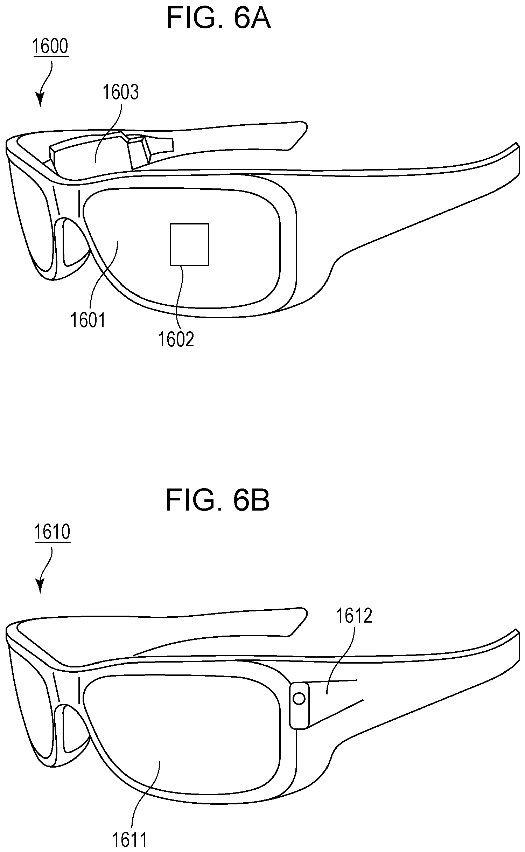

Examples of applications of the display apparatuses of the above embodiments will be described with reference to Figs. 6A and 6B. The display apparatuses can be used for systems that can be worn as wearable devices, such as smart glasses, head-mounted displays (HMDs), and smart contacts. An image pickup and display apparatus used in such an example of the applications has an image pickup apparatus that can photoelectrically convert visible light and a display apparatus that can emit visible light.

Fig. 6A is a schematic view illustrating an example of a wearable device according to an embodiment of the present disclosure. Glasses 1600 (smart glasses) according to an example of applications will be described with reference to Fig. 6A. An image pickup apparatus 1602, such as a complementary metal-oxide semiconductor (CMOS) sensor or a single-photon avalanche diode (SPAD), is provided on a front side of a lens 1601 of the glasses 1600. The display apparatus according to any of the above-mentioned embodiments is provided on the back side of the lens 1601.

The glasses 1600 further include a control unit 1603. The control unit 1603 functions as a power source that supplies electric power to the image pickup apparatus 1602 and the display apparatus. The control unit 1603 controls the operation of the image pickup apparatus 1602 and the display apparatus. The lens 1601 has an optical system for focusing light on the image pickup apparatus 1602.

Fig. 6B is a schematic view illustrating another example of a wearable device according to an embodiment of the present disclosure. Glasses 1610 (smart glasses) according to an example of applications will be described with reference to Fig. 6B. The glasses 1610 include a control unit 1612. The control unit 1612 includes an image pickup apparatus corresponding to the image pickup apparatus 1602 illustrated in Fig. 6A and a display apparatus. A lens 1611 is provided with the image pickup apparatus in the control unit 1612 and an optical system that projects light emitted from the display apparatus. An image is projected onto the lens 1611. The control unit 1612 functions as a power source that supplies electric power to the image pickup apparatus and the display apparatus and controls the operation of the image pickup apparatus and the display apparatus.

The control unit 1612 may include a gaze detection unit that detects the gaze of a wearer. Infrared light may be used for gaze detection. An infrared light-emitting unit emits infrared light to an eyeball of a user who is gazing at a displayed image. An image of the eyeball is captured by detecting the reflected infrared light from the eyeball with an image pickup unit having light-receiving elements. The deterioration of image quality is reduced by providing a reduction unit that reduces light from the infrared light-emitting unit to the display unit when viewed in plan. The user's gaze at the displayed image is detected from the image of the eyeball captured with the infrared light. Any known method can be employed to the gaze detection using the captured image of the eyeball. As an example, a gaze detection method based on a Purkinje image of the reflection of irradiation light on a cornea can be employed. More specifically, the gaze detection process is based on a pupil-corneal reflection method. Using the pupil-corneal reflection method, the user's gaze is detected by calculating a gaze vector representing the direction (rotation angle) of the eyeball based on the image of the pupil and the Purkinje image contained in the captured image of the eyeball.

A display apparatus according to an embodiment of the present disclosure may include an image pickup apparatus including light-receiving elements, and may control an image displayed on the display apparatus based on the gaze information of the user from the image pickup apparatus. Specifically, in the display apparatus, a first field-of-view area at which the user gazes and a second field-of-view area other than the first field-of-view area are determined on the basis of the gaze information. The first field-of-view area and the second field-of-view area may be determined by the control unit of the display apparatus or may be determined by receiving those determined by an external control unit. In the display area of the display apparatus, the display resolution of the first field-of-view area may be controlled to be higher than the display resolution of the second field-of-view area. That is, the resolution of the second field-of-view area may be lower than that of the first field-of-view area.

The display area includes a first display area and a second display area different from the first display area. Based on the gaze information, an area of higher priority is determined from the first display area and the second display area. The first display area and the second display area may be determined by the control unit of the display apparatus or may be determined by receiving those determined by an external control unit. The resolution of an area of higher priority may be controlled to be higher than the resolution of an area other than the area of higher priority. In other words, the resolution of an area of a relatively low priority may be low.

Artificial intelligence (AI) may be used to determine the first field-of-view area or the high-priority area. The AI may be a model configured to estimate the angle of gaze from the image of the eyeball and the distance to a target object located in the gaze direction, using the image of the eyeball and the actual direction of gaze of the eyeball in the image as teaching data. The AI program may be stored in the display apparatus, the image pickup apparatus, or an external apparatus. When the AI program is stored in the external apparatus, the AI program is transmitted to the display apparatus via communications.

In the case of controlling the display based on visual detection, smart glasses that further include an image pickup apparatus that captures an external image can be used. The smart glasses can display the captured external information in real time.

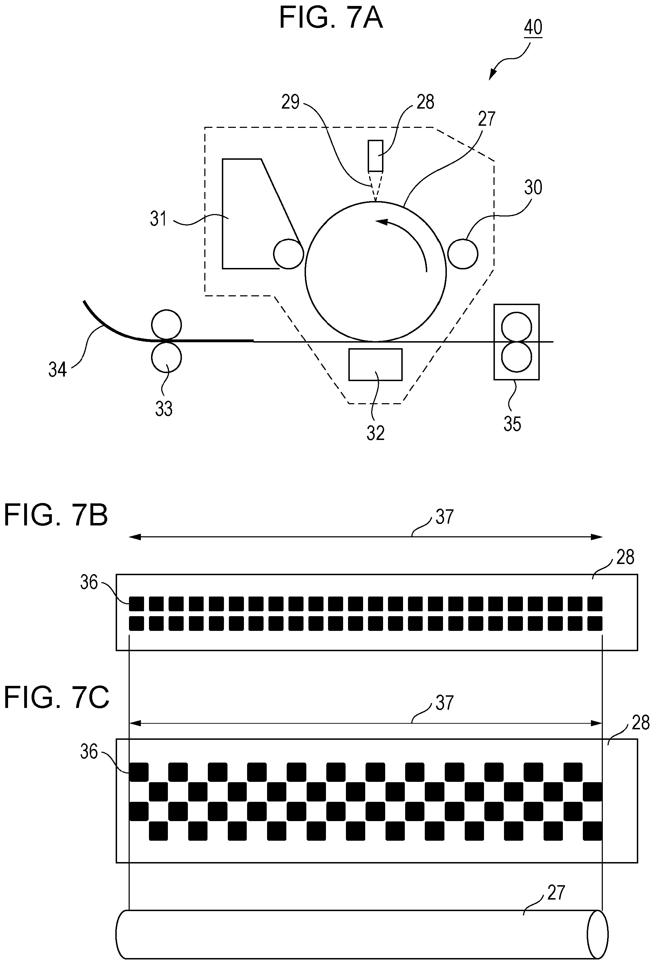

Fig. 7A is a schematic view of an example of an image-forming apparatus according to an embodiment of the present disclosure. An image-forming apparatus 40 is an electrophotographic image-forming apparatus and includes a photoconductor 27, an exposure light source 28, a charging unit 30, a developing unit 31, a transfer unit 32, a transport roller 33, and a fusing unit 35. The irradiation of light 29 is performed from the exposure light source 28 to form an electrostatic latent image on the surface of the photoconductor 27. The exposure light source 28 includes the organic light-emitting device according to the present embodiment. The developing unit 31 contains, for example, a toner. The charging unit 30 charges the photoconductor 27. The transfer unit 32 transfers the developed image to a recording medium 34. The transport roller 33 transports the recording medium 34. The recording medium 34 is paper, for example. The fusing unit 35 fixes the image formed on the recording medium 34.

Figs. 7B and 7C each illustrate the exposure light source 28 and are each a schematic view illustrating multiple light-emitting portions 36 arranged on a long substrate. Arrows 37 are parallel to the axis of the photoconductor and each represent the row direction in which the organic light-emitting devices are arranged. The row direction is the same as the direction of the axis on which the photoconductor 27 rotates. This direction can also be referred to as the long-axis direction of the photoconductor 27. Fig. 7B illustrates a configuration in which the light-emitting portions 36 are arranged in the long-axis direction of the photoconductor 27. Fig. 7C is different from Fig. 7B in that the light-emitting portions 36 are arranged alternately in the row direction in a first row and a second row. The first row and the second row are located at different positions in the column direction. In the first row, the multiple light-emitting portions 36 are spaced apart. The second row has the light-emitting portions 36 at positions corresponding to the positions between the light-emitting portions 36 in the first row. In other words, the multiple light-emitting portions 36 are also spaced apart in the column direction. The arrangement in Fig. 7C can be rephrased as, for example, a lattice arrangement, a staggered arrangement, or a checkered pattern.

As described above, the use of an apparatus including the organic light-emitting device according to the present embodiment enables a stable display with good image quality even for a long time.

### EXAMPLES

### Example 1

An organic light-emitting device having a bottom-emission structure was produced in which an anode, a hole injection layer, a hole transport layer, an electron-blocking layer, a first light-emitting layer, a second light-emitting layer, a hole-blocking layer, an electron transport layer, an electron injection layer, and a cathode were sequentially formed on a substrate.

An ITO film was formed on a glass substrate and subjected to desired patterning to form an ITO electrode (anode). The ITO electrode had a thickness of 100 nm. The substrate on which the ITO electrode had been formed in this way was used as an ITO substrate in the following steps. Next, vapor deposition was performed by resistance heating in a vacuum chamber at 1.33 × 10⁻⁴ Pa to continuously form organic compound layers and an electrode layer presented in Table 5 on the ITO substrate. Here, the opposing electrode (metal electrode layer, cathode) had an electrode area of 3 mm².

**Table 5**

| | Material | | | Thickness (nm) |
|---|---|---|---|---|
| Cathode | Al | | | 100 |
| Electron injection layer (EIL) | LiF | | | 1 |
| Electron transport layer (ETL) | ET2 | | | 20 |
| Hole-blocking layer (HBL) | ET11 | | | 20 |
| Second light-emitting layer | second host | EM2 | weight ratio EM1:BD6 = 98.5:1.5 | 10 |
| | second guest | BD6 | | |
| First light-emitting layer | first host | EM2 | weight ratio EM2:RD21:GD5 = 99.5:0.5:3.0 | 10 |
| | first guest | RD21 | | |
| | third guest | GD5 | | |
| Electron-blocking layer (HBL) | HT19 | | | 15 |
| Hole transport layer (HTL) | HT3 | | | 30 |
| Hole injection layer (HIL) | HT16 | | | 5 |

The characteristics of the resulting device were measured and evaluated. The emission color of the light-emitting device was white, and the maximum external quantum efficiency (E.Q.E.) was 7%. The device was subjected to a continuous operation test at a current density of 100 mA/cm². The time when the percentage of luminance degradation reached 5% was measured. When the time when the percentage of luminance degradation of Comparative example 1 described below reached 5% was set to 1.0, the percentage ratio of luminance degradation was determined and found to be 2.5.

With regard to measurement instruments, in the Examples, the current-voltage characteristics were measured with a Hewlett-Packard 4140B microammeter, and the luminance was measured with a Topcon BM7.

### Examples 2 to 21 and Comparative Examples 1 to 6

Organic light-emitting devices were produced in the same manner as in Example 1, except that the compounds were changed to compounds given in Table 6 as appropriate. The characteristics of the resulting device were measured and evaluated as in Example 1. Table 6 presents the measurement results. Comparative compounds 4 and 5 are as illustrated below, and comparative compound 5 is 1,4-bis(4-ditolylamino-p-styryl)benzene (DTASB) described in U.S. Patent Application Publication No. 2004/0241491.

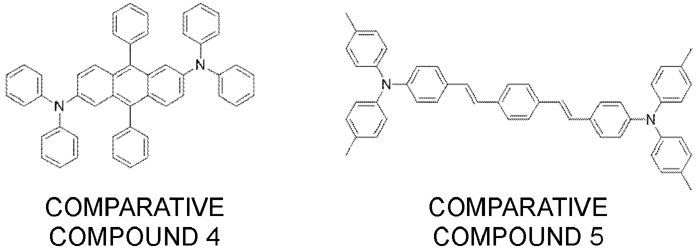

**Table 6**

| | First EML | | | Second EML | | HBL | E.Q.E. [%] | Percentage ratio of luminance degradation |
|---|---|---|---|---|---|---|---|---|
| | First host | First guest | Third guest | Second host | Second guest | | | |
| Example 2 | EM3 | RD21 | GD5 | EM3 | BD6 | ET11 | 7 | 2.5 |
| Example 3 | EM9 | RD1 | GD5 | EM9 | BD6 | ET12 | 7 | 2.4 |
| Example 4 | EM10 | RD1 | GD5 | EM10 | BD6 | ET11 | 7 | 2.4 |
| Example 5 | EM12 | RD16 | GD15 | EM12 | BD14 | ET10 | 7 | 2.3 |
| Example 6 | EM21 | RD24 | GD12 | EM20 | BD14 | ET10 | 7 | 2.3 |
| Example 7 | EM20 | RD27 | GD24 | EM21 | BD22 | ET11 | 7 | 2.1 |
| Example 8 | EM26 | RD2 | GD6 | EM26 | BD16 | ET11 | 7 | 2.5 |
| Example 9 | EM27 | RD4 | GD25 | EM27 | BD17 | ET10 | 7 | 2.4 |
| Example 10 | EM33 | RD12 | GD5 | EM33 | BD13 | ET10 | 7 | 2.3 |
| Example 11 | EM37 | RD23 | GD24 | EM37 | BD25 | ET11 | 7 | 2.0 |
| Example 12 | EM43 | RD21 | GD4 | EM43 | BD6 | ET10 | 7 | 2.3 |
| Example 13 | EM45 | RD21 | GD5 | EM45 | BD14 | ET10 | 7 | 2.2 |
| Example 14 | EM2 | RD23 | GD26 | EM9 | BD6 | ET11 | 8 | 2.4 |
| Example 15 | EM4 | RD10 | GD13 | EM9 | BD30 | ET10 | 8 | 2.4 |
| Example 16 | EM21 | RD8 | GD5 | EM17 | BD35 | ET10 | 8 | 2.2 |
| Example 17 | EM26 | RD21 | GD5 | EM28 | BD32 | ET11 | 8 | 2.2 |
| Example 18 | EM30 | RD21 | GD28 | EM6 | BD16 | ET10 | 6 | 2.1 |
| Example 19 | EM8 | RD13 | GD5 | EM12 | BD6 | ET10 | 8 | 2.3 |
| Example 20 | EM23 | RD11 | GD5 | EM9 | BD6 | ET10 | 8 | 2.3 |
| Comparative example 1 | comparative compound 1 | RD21 | GD5 | comparative compound 1 | BD6 | ET11 | 7 | 1.0 |
| Comparative example 2 | comparative compound 2 | RD21 | GD5 | comparative compound 2 | BD6 | ET11 | 7 | 1.1 |
| Comparative example 3 | comparative compound 2 | RD21 | GD5 | comparative compound 2 | BD6 | comparative compound 2 | 6 | 0.8 |
| Comparative example 4 | comparative compound 3 | RD21 | GD5 | comparative compound 3 | BD6 | ET11 | 7 | 1.1 |
| Example 21 | EM2 | compound 1 | GD5 | EM2 | BD6 | ET11 | 6 | 1.8 |
| Comparative example 5 | EM2 | RD21 | comparative compound 4 | EM2 | BD6 | ET11 | 7 | 0.8 |
| Comparative example 6 | EM2 | RD21 | HT19 | EM2 | comparative compound 5 | ET11 | 7 | 0.4 |

The results of Examples 1 to 20 indicated that the white organic light-emitting devices according to the present embodiment had superior durability characteristics and highly efficient light emission characteristics. In contrast, in comparative examples 1 to 4, the durability characteristics were poor.

In the case of Comparative example 1, the host material of the light-emitting layer was comparative compound 1 having multiple SP³ carbon atoms; thus, bond cleavage and radical formation during the driving of the device and a decrease in compatibility with the guest material is considered to have adversely affected the driving durability of the device.

In the case of Comparative examples 2 to 4, the host materials of the light-emitting layers are compounds having high linearity and easily subjected to molecular aggregation; thus, a deterioration in film property is considered to have adversely affected the driving durability of the devices. In particular, in the case of Comparative example 3, the material of HBL also has poor film properties, resulting in poor durability characteristics.

The reasons why the driving durability of the device of Example 21 is inferior to those of Examples 1 to 20 is considered to be as follows: a difficulty in forming a high-purity vapor-deposited film due to low sublimability of the first guest, and poor compatibility with the host due to the presence of multiple SP³ carbon atoms of the first guest.

In the case of Comparative example 5, the third guest is an amine compound and has a carbon-nitrogen bond with low bond stability; thus, the bond is easily cleaved during the driving of the device. This is considered to have adversely affected the driving durability of the device.

In the case of Comparative example 6, the second guest is an amine compound and has a carbon-nitrogen bond with low bond stability; thus, the bond is easily cleaved during the driving of the device. This is considered to have adversely affected the driving durability of the device.

### Examples 22 to 31

Organic light-emitting devices were produced in the same manner as in Example 1, except that the compounds, excluding the compounds in the light-emitting layers, were appropriately changed as given in Table 7. The characteristics of the resulting devices were measured and evaluated as in Example 1. Table 7 presents the measurement results.

**Table 7**

| | HIL | HTL | EBL | HBL | ETL | E.Q.E. [%] | Percentage ratio of luminance degradation |
|---|---|---|---|---|---|---|---|
| Example 22 | HT16 | HT1 | HT8 | ET16 | ET3 | 7 | 2.1 |
| Example 23 | HT16 | HT2 | HT8 | ET10 | ET3 | 7 | 2.4 |
| Example 24 | HT16 | HT2 | HT7 | ET10 | ET3 | 7 | 2.4 |
| Example 25 | HT16 | HT2 | HT7 | ET15 | ET3 | 7 | 2.1 |
| Example 26 | HT16 | HT1 | HT14 | ET15 | ET3 | 7 | 2.1 |
| Example 27 | HT16 | HT2 | HT14 | ET10 | ET7 | 7 | 2.4 |
| Example 28 | HT16 | HT2 | HT10 | ET22 | ET18 | 7 | 2.2 |
| Example 29 | HT16 | HT6 | HT10 | ET19 | ET19 | 7 | 2.0 |
| Example 30 | HT16 | HT6 | HT12 | ET18 | ET14 | 7 | 2.1 |
| Example 31 | HT16 | HT6 | HT12 | ET23 | ET5 | 7 | 2.2 |

### Examples 32 to 38

Organic light-emitting devices were produced in the same manner as in Example 1, except that the compounds and guest concentrations were appropriately changed as given in Table 8. The characteristics of the resulting devices were measured and evaluated as in Example 1. Table 8 presents the measurement results.

In addition, emission spectra at a low current density of 0.01 mA/cm² were evaluated. When the peak height originating from the red guest is 1.0 in each emission spectrum, the peak height of each of the blue guest and the green guest is evaluated. A peak height of less than 0.1 was rated as "poor", a peak height of 0.1 or more and less than 0.5 was rated as "fair", and a peak height of 0.5 or more was rated as "good". In the case of sufficiently high peak heights of blue light emission and green light emission, white light emission can be satisfactorily obtained even at a low current density, that is, low luminance. Table 8 presents the results.

**Table 8**

| | Second EML | | | E.Q.E. [%] | Percentage ratio of luminance degradation | Peak height ratio | |
|---|---|---|---|---|---|---|---|
| | Second host | Second guest | Second guest concentration | | | Blue | Green |
| Example 32 | EM2 | BD23 | 1.0% | 7 | 3.3 | fair | good |
| Example 33 | EM2 | BD23 | 1.2% | 7 | 3.1 | good | good |
| Example 34 | EM2 | BD23 | 2.0% | 7 | 2.4 | good | good |
| Example 35 | EM2 | BD23 | 2.5% | 7 | 2.0 | good | good |
| Example 36 | EM2 | BD23 | 3.0% | 7 | 1.8 | good | good |
| Example 37 | EM2 | BD23 | 0.8% | 7 | 3.6 | fair | good |
| Example 38 | EM2 | BD23 | 3.2% | 4 | 1.3 | good | good |

The results of Examples 32 to 37 indicated that the white light-emitting devices according to the present embodiment had superior durability characteristics and emitted well-balanced white light of red, green, and blue in the low luminance region.

The results of Example 38 indicated that well-balanced white light emission was obtained. However, the durability characteristics and the efficiency characteristics were inferior to those in Examples 32 to 37. The reason for this is presumably that the higher concentration of the guest material in the blue light-emitting layer than those in Examples 32 to 37 have resulted in lower efficiency due to concentration quenching. Another reason is presumably that the larger amount of blue light-emitting material having a high energy in the excited state in the light-emitting layer than those in Examples 32 to 37 have caused a side reaction and so forth in the light-emitting layer.

### Example 39

In this Example, an organic light-emitting device having a top-emission structure was produced in which an anode, a hole injection layer, a hole transport layer, an electron-blocking layer, a first light-emitting layer, a second light-emitting layer, a hole-blocking layer, an electron transport layer, an electron injection layer, and a cathode were sequentially formed on a substrate.

First, a Ti film having a thickness of 40 nm was formed by a sputtering method on the substrate and patterned using a known photolithography technique, thereby forming the anode. Here, the formation of the anode was performed in such a manner that the opposing electrode (metal electrode layer, cathode) had a pixel area of 3 mm². Subsequently, the cleaned substrate on which the electrode had been formed and materials were attached to a vacuum deposition apparatus (available from ULVAC, Inc). The apparatus was evacuated to 1.33 × 10⁻⁴ Pa (1 × 10⁻⁶ Torr), and then UV/ozone cleaning was performed. Thereafter, each layer was formed so as to achieve the layer configuration given in Table 9.

**Table 9**

| | Material | | | Thickness (nm) |
|---|---|---|---|---|
| Electron transport layer (ETL) | ET3 | | | 20 |
| Hole-blocking layer (HBL) | ET11 | | | 20 |
| Second light-emitting layer | Second host | EM10 | Mass ratio EM1 : BD23 =98.5 : 1.5 | 10 |
| | Second guest | BD23 | | |
| First light-emitting layer | First host | EM10 | Mass ratio EM2 : RD21 : GD5 =96.5 : 0.5 : 3.0 | 13 |
| | First guest | RD21 | | |
| | Third guest | GD5 | | |
| Electron-blocking layer (EBL) | HT12 | | | 15 |
| Hole transport layer (HTL) | HT3 | | | 30 |
| Hole injection layer (HIL) | HT16 | | | 5 |

After the formation of the electron transport layer, a lithium fluoride film having a thickness of 0.5 nm was formed as an electron injection layer. Thereafter, a MgAg alloy film having a thickness of 10 nm was formed as a cathode layer. The ratio of Mg to Ag was 1:1. Then a SiN film having a thickness of 1.5 µm was formed as a sealing layer by a chemical vapor deposition (CVD) method.

The characteristics of the resulting organic light-emitting device were measured and evaluated. When the resulting organic light-emitting device was displayed at 1,000 cd/m², the efficiency was 7.2 cd/A, the voltage was 3.6 V, and the CIE chromaticity coordinates were (0.25, 0.31). That is, the resulting organic light-emitting device was a good white organic light-emitting device having high efficiency and low device driving voltage. The device was subjected to a continuous operation test at a current density of 100 mA/cm². The time when the percentage of luminance degradation reached 5% was measured. When the time when the percentage of luminance degradation of Comparative example 7 described below reached 5% was set to 1.0, the percentage ratio of luminance degradation was determined and found to be 2.8.

### Examples 40 to 48 and Comparative Example 7

White organic light-emitting devices were produced in the same manner as in Example 39, except that the compounds of the first light-emitting layer and the second light-emitting layer were changed to the compounds given in Table 10 as appropriate. The characteristics of the resulting organic light-emitting devices were measured and evaluated as in Example 39. Table 10 presents the measurement results.

**Table 10**

| | First EML | | | Second EML | | Efficiency [Cd/A] | Percentage ratio of luminance degradation |
|---|---|---|---|---|---|---|---|
| | First host | First guest | Third guest | Second host | Second guest | | |
| Example 40 | EM2 | RD21 | GD5 | EM2 | BD6 | 7.1 | 2.5 |
| Example 41 | EM2 | RD1 | GD5 | EM2 | BD6 | 7.3 | 2.4 |
| Example 42 | EM2 | RD1 | GD5 | EM12 | BD6 | 7.1 | 2.4 |
| Example 43 | EM2 | RD16 | GD15 | EM12 | BD14 | 6.9 | 2.3 |
| Example 44 | EM21 | RD31 | GD12 | EM20 | BD22 | 6.8 | 2.1 |
| Example 45 | EM22 | RD27 | GD6 | EM21 | BD26 | 7.2 | 2.1 |
| Example 46 | EM2 | RD2 | GD6 | EM26 | BD8 | 7.3 | 2.0 |
| Example 47 | EM27 | RD4 | GD24 | EM27 | BD22 | 7.1 | 2.1 |
| Example 48 | EM33 | RD12 | GD10 | EM33 | BD32 | 7.0 | 2.1 |
| Comparative example 7 | comparative compound 1 | RD21 | GD5 | comparative compound 1 | BD23 | 6.9 | 1.0 |

The results of Examples 40 to 48 indicated that the white organic light-emitting devices according to the present embodiment had superior durability characteristics and highly efficient light emission characteristics.

In Comparative example 7, the durability characteristics were not good. In the case of Comparative example 7, the host material of the light-emitting layer was comparative compound 1 having multiple SP³ carbon atoms; thus, bond cleavage and radical formation during the driving of the device and a decrease in compatibility with the guest material is considered to have adversely affected the driving durability of the device.

According to an embodiment of the present disclosure, it is possible to provide an organic light-emitting device, in particular, a white organic light-emitting device, having improved durability characteristics.

While the present disclosure has been described with reference to exemplary embodiments, it is to be understood that the invention is not limited to the disclosed exemplary embodiments.

## Claims

1. An organic light-emitting device (26), comprising, in sequence:
an anode (21);
a first light-emitting layer (43);
a second light-emitting layer (44); and
a cathode (23),
wherein the first light-emitting layer (43) contains a first host and a first guest that fluoresces,
the second light-emitting layer (44) contains a second host and a second guest that fluoresces,
the first light-emitting layer (43) and the second light-emitting layer (44) contain no amine compound, and
each of the first host and the second host is a hydrocarbon compound whose carbon atoms are SP² carbon atoms only and
**characterized in that** each of the first host and the second host has any of structures represented by the following formulae [1] to [6]: 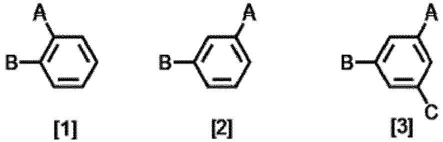 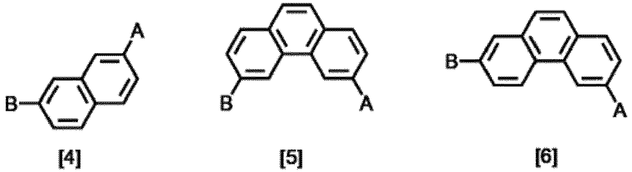 where in formula [1] to [6], A to C are each an anthracene residue, a pyrene residue, a benzanthracene residue, a benzpyrene residue, a phenanthrene residue, or a fluoranthene residue, and each of A to C optionally further contain a phenyl group, a biphenyl group, a terphenyl group, or a naphthyl group.

2. The organic light-emitting device (26) according to Claim 1, wherein the first guest is a hydrocarbon compound whose carbon atoms are SP² carbon atoms only and emits red fluorescence, and
the second guest has a light emission range that lies at shorter wavelengths than the first guest.

3. The organic light-emitting device (26) according to Claim 1 or 2, wherein the first guest has a partial structure represented by any of the following formulae [7] to [10]. 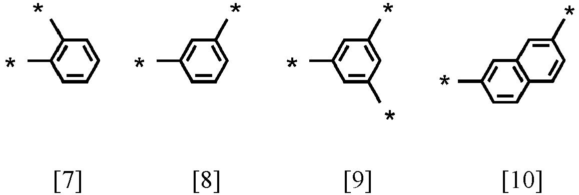 where in formulae [7] to [10], each * represents a binding position with a carbon atom.

4. The organic light-emitting device (26) according to any one of Claims 1 to 3, wherein the first light-emitting layer (43) has a thickness equal to or larger than the second light-emitting layer (44).

5. The organic light-emitting device (26) according to any one of Claims 1 to 4, wherein a concentration of the second guest in the second light-emitting layer (44) is 1.0% or more by mass and 3.0% or less by mass.

6. The organic light-emitting device (26) according to any one of Claims 1 to 5, wherein the first light-emitting layer (43) further contains a third guest that fluoresces.

7. The organic light-emitting device (26) according to Claim 6, wherein each of the first guest, the second guest, and the third guest has a partial structure containing two or more fluoranthene skeletons.

8. The organic light-emitting device (26) according to any one of Claims 1 to 7, wherein the second guest does not contain an electron-withdrawing substituent or an electron-donating substituent.

9. The organic light-emitting device (26) according to any one of Claims 1 to 8, wherein the organic light-emitting device (26) emits white light.

10. A display apparatus (100), comprising:
multiple pixels,
wherein at least one of the multiple pixels includes:
the organic light-emitting device (26) according to any one of Claims 1 to 9, and
a transistor (18) coupled to the organic light-emitting device (26).

11. A photoelectric conversion apparatus, comprising:
an optical unit including multiple lenses;
an image pickup device arranged to receive light passing through the optical unit; and
a display unit arranged to display an image captured by the image pickup device,
wherein the display unit includes the organic light-emitting device (26) according to any one of Claims 1 to 9.

12. An electronic apparatus (1200), comprising:
a display unit (1201) including the organic light-emitting device (26) according to any one of Claims 1 to 9;
a housing (1203) provided with the display unit (1201); and
a communication unit being disposed in the housing and communicating with an outside.

13. A lighting apparatus (1400), comprising:
a light source (1402) including the organic light-emitting device (26) according to any one of Claims 1 to 9; and
a light diffusion unit (1405) or an optical filter (1404) arranged to transmit light emitted from the light source (1402).

14. A moving object, comprising:
a lighting unit including the organic light-emitting device (26) according to any one of Claims 1 to 9; and
a body provided with the lighting unit.

15. An exposure light source (28) for an electrophotographic image-forming apparatus (40), comprising:
the organic light-emitting device (26) according to any one of Claims 1 to 9.

## Patentansprüche

1. Organisches lichtemittierendes Vorrichtung (26), der Reihe nach umfassend:
eine Anode (21);
eine erste lichtemittierende Schicht (43);
eine zweite lichtemittierende Schicht (44); und
eine Kathode (23),
wobei die erste lichtemittierende Schicht (43) einen ersten Wirt und einen ersten fluoreszierenden Gast enthält,
die zweite lichtemittierende Schicht (44) einen zweiten Wirt und einen zweiten fluoreszierenden Gast enthält,
die erste lichtemittierende Schicht (43) und die zweite lichtemittierende Schicht (44) keine Aminverbindung enthalten, und
der erste Wirt und der zweite Wirt sind jeweils Kohlenwasserstoffverbindungen, deren Kohlenstoffatome nur sp²-Kohlenstoffatome sind, und **dadurch gekennzeichnet sind, dass** der erste Wirt und der zweite Wirt jeweils eine Struktur aufweisen, die durch eine der folgenden Formeln [1] bis [6] dargestellt werden: 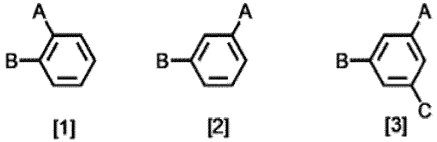 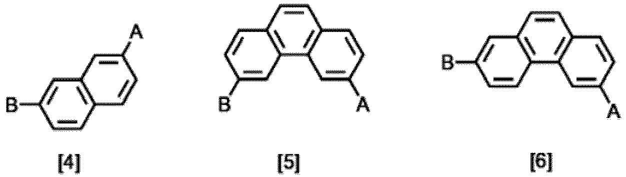 wobei, in den Formeln [1] bis [6], A bis C jeweils ein Anthracen-Rest, ein Pyren-Rest, ein Benzanthracen-Rest, ein Benzpyren-Rest, ein Phenanthren-Rest oder ein Fluoranthen-Rest sind, und jedes von A bis C optional ferner eine PhenylGruppe, eine Biphenyl-Gruppe, eine Terphenyl-Gruppe oder eine NaphthylGruppe enthalten.

2. Die organische lichtemittierende Vorrichtung (26) nach Anspruch 1, wobei der erste Gast eine Kohlenwasserstoffverbindung ist, deren Kohlenstoffatome nur sp²-Kohlenstoffatome sind und rote Fluoreszenz emittiert, und
der zweite Gast einen Lichtemissionsbereich aufweist, der bei kürzeren Wellenlängen als der erste Gast liegt.

3. Die organische lichtemittierende Vorrichtung (26) nach Anspruch 1 oder 2, wobei der erste Wirt eine Teilstruktur aufweist, die durch eine der folgenden Formeln [7] bis [10] dargestellt wird 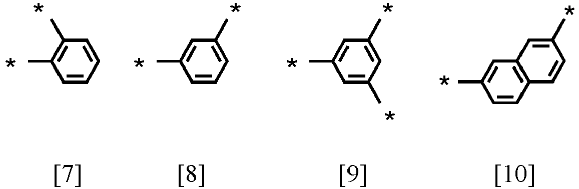 wobei in Formeln [7] to [10], jeder * eine Bindungsstelle mit einem Kohlenstoffatom darstellt.

4. Die organische lichtemittierende Vorrichtung (26) nach einem der Ansprüche 1 bis 3,
wobei die erste lichtemittierende Schicht (43) eine Dicke aufweist, die gleich oder größer als die Dicke der zweiten lichtemittierende Schicht (44) ist.

5. Die organische lichtemittierende Vorrichtung (26) nach einem der Ansprüche 1 bis 4,
wobei eine Konzentrazion des zweiten Gastes in der zweiten lichtemittierenden Schicht (44) 1,0 Massen-% oder mehr und 3,0 Massen-% oder weniger ist.

6. Die organische lichtemittierende Vorrichtung (26) nach einem der Ansprüche 1 bis 5,
wobei die erste lichtemittierende Schicht (43) ferner einen dritten fluoreszierenden Gast enthält.

7. Die organische lichtemittierende Vorrichtung (26) nach Anspruch 6,
wobei der erste Gast, der zweite Gast und der dritte Gast jeweils eine Teilstruktur aufweist, die zwei oder mehr Fluoranthenskelette enthält.

8. Die organische lichtemittierende Vorrichtung (26) nach einem der Ansprüche 1 bis 7,
wobei der zweite Gast keinen elektronenziehenden Substituenten oder elektronenliefernden Substituenten enthält.

9. Die organische lichtemittierende Vorrichtung (26) nach einem der Ansprüche 1 bis 8,
wobei die organische lichtemittierende Vorrichtung (26) weißes Licht emittiert.

10. Displayapparat (100), umfassend:
mehrere Pixel,
wobei mindestends eines der mehreren Pixel enthält:
die organische lichtemittierende Vorrichtung (26) nach einem der Ansprüche 1 bis 9, und
einen Transistor, der mit der organischen lichtemittierenden Vorrichtung (26) gekoppelt ist.

11. Photoelektrischer Umwandlungsapparat, umfassend:
eine mehreren Linsen enthaltende optische Einheit,
eine Bildaufnahmevorrichtung, die ausgebildet ist, um durch die optische Einheit hindurchtretendes Licht zu empfangen, und
eine Anzeigeeinheit, die ausgebildet ist, um ein von der Bildaufnahmevorrichtung aufgenommenes Bild anzuzeigen,
wobei die Anzeigeeinheit die organische lichtemittierende Vorrichtung (26) nach einem der Ansprüche 1 bis 9 enthält.

12. Elektronischer Apparat (1200), umfassend:
eine Anzeigeeinheit (1201), die die organische lichtemittierende Vorrrichtung (26) nach einem der Ansprüche 1 bis 9 enthält;
ein Gehäuse (1203), das mit der Anzeigeeinheit (1201) ausgestattet ist; und
eine Kommunikationseinheit, die in dem Gehäuse angeordnet ist und mit einer Außenseite kommuniziert.

13. Beleuchtungsvorrichtung (1400), umfassend:
eine Lichtquelle (1402), die die organische lichtemittierende Vorrrichtung (26) nach einem der Ansprüche 1 bis 9 enthält; und
eine Lichtstreuungseinheit (1405) oder einen optischen Filter (1404), die angeordnet sind, um das von der Lichtquelle (1402) emittierte Licht durchzulassen.

14. Beweglisches Objekt, umfassend:
eine Beleuchtungseinheit, die die organische lichtemittierende Vorrichtung (26) nach einem der Ansprüche 1 bis 9 enthält; und
einen Körper, der mit der Beleuchtungseinheit ausgestattet ist.

15. Belichtungslichtquelle (28) für einen elektrofotografische Bilderzeugungsapparat (40), umfassend:
die organische lichtemittierende Vorrichtung (26) nach einem der Ansprüche 1 bis 9 enthält.

## Revendications

1. Dispositif électroluminescent organique (26), comprenant, de manière séquentielle :
une anode (21) ;
une première couche électroluminescente (43) ;
une seconde couche électroluminescente (44) ; et
une cathode (23),
dans lequel la première couche électroluminescente (43) contient un premier hôte et un premier invité qui fluoresce,
la seconde couche électroluminescente (44) contient un second hôte et un deuxième invité qui fluoresce,
la première couche électroluminescente (43) et la seconde couche électroluminescente (44) ne contiennent aucun composé amine, et
chacun du premier hôte et du second hôte est un composé hydrocarboné dont les atomes de carbone sont des atomes de carbone SP² uniquement et
**caractérisé en ce que** chacun du premier hôte et du second hôte a l'une quelconque des structures représentées par les formules [1] à [6] suivantes : 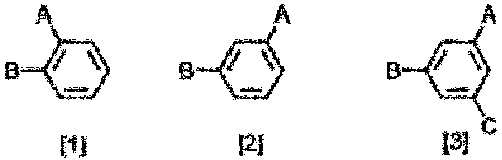 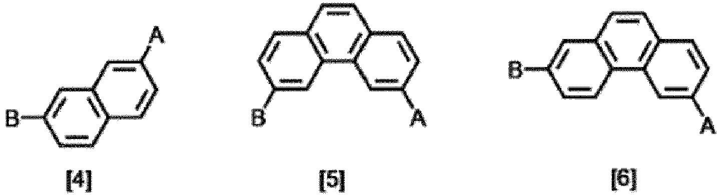
où dans les formules [1] à [6], A à C sont chacun un résidu d'anthracène, un résidu de pyrène, un résidu de benzanthracène, un résidu de benzopyrène, un résidu de phénanthrène, ou un résidu de fluoranthène, et chacun de A à C contient optionnellement en outre un groupe phényle, un groupe biphényle, un groupe terphényle, ou un groupe naphtyle.

2. Dispositif électroluminescent organique (26) selon la revendication 1, dans lequel le premier invité est un composé hydrocarboné dont les atomes de carbone sont des atomes de carbone SP² uniquement et émet une fluorescence rouge, et
le deuxième invité a une plage d'émission de lumière qui se situe à des longueurs d'onde plus courtes que le premier invité.

3. Dispositif électroluminescent organique (26) selon la revendication 1 ou 2, dans lequel le premier invité a une structure partielle représentée par l'une quelconque des formules [7] à [10] suivantes : 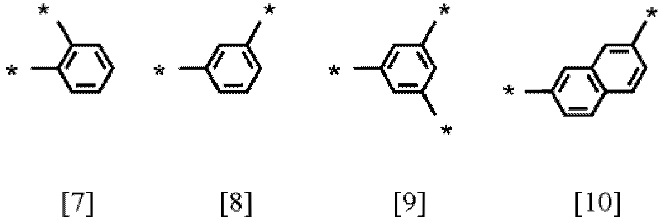 où dans les formules [7] à [10], chaque * représente une position de liaison avec un atome de carbone.

4. Dispositif électroluminescent organique (26) selon l'une quelconque des revendications 1 à 3, dans lequel la première couche électroluminescente (43) a une épaisseur égale à ou plus grande que la seconde couche électroluminescente (44).

5. Dispositif électroluminescent organique (26) selon l'une quelconque des revendications 1 à 4, dans lequel une concentration du deuxième invité dans la seconde couche électroluminescente (44) est de 1,0 % ou plus en masse et de 3,0 % ou moins en masse.

6. Dispositif électroluminescent organique (26) selon l'une quelconque des revendications 1 à 5, dans lequel la première couche électroluminescente (43) contient en outre un troisième invité qui fluoresce.

7. Dispositif électroluminescent organique (26) selon la revendication 6, dans lequel chacun du premier invité, du deuxième invité, et du troisième invité a une structure partielle contenant deux squelettes de fluoranthène ou plus.

8. Dispositif électroluminescent organique (26) selon l'une quelconque des revendications 1 à 7, dans lequel le deuxième invité ne contient ni substituant attracteur d'électrons, ni substituant donneur d'électrons.

9. Dispositif électroluminescent organique (26) selon l'une quelconque des revendications 1 à 8, dans lequel le dispositif électroluminescent organique (26) émet une lumière blanche.

10. Appareil d'affichage (100), comprenant :
de multiples pixels,
dans lequel au moins un parmi les multiples pixels comprend :
le dispositif électroluminescent organique (26) selon l'une quelconque des revendications 1 à 9, et
un transistor (18) couplé au dispositif électroluminescent organique (26).

11. Appareil de conversion photoélectrique, comprenant :
une unité optique comprenant de multiples lentilles ;
un dispositif de prise de vue agencé pour recevoir la lumière passant à travers l'unité optique ; et
une unité d'affichage agencée pour afficher une image capturée par le dispositif de prise de vue,
dans lequel l'unité d'affichage comprend le dispositif électroluminescent organique (26) selon l'une quelconque des revendications 1 à 9.

12. Appareil électronique (1200), comprenant :
une unité d'affichage (1201) comprenant le dispositif électroluminescent organique (26) selon l'une quelconque des revendications 1 à 9 ;
un boîtier (1203) pourvu de l'unité d'affichage (1201) ; et
une unité de communication disposée dans le boîtier et communiquant avec un extérieur.

13. Appareil d'éclairage (1400), comprenant :
une source de lumière (1402) comprenant le dispositif électroluminescent organique (26) selon l'une quelconque des revendications 1 à 9 ; et
une unité de diffusion de lumière (1405) ou un filtre optique (1404) agencés pour transmettre la lumière émise à partir de la source de lumière (1402).

14. Objet mobile, comprenant :
une unité d'éclairage comprenant le dispositif électroluminescent organique (26) selon l'une quelconque des revendications 1 à 9 ; et
un corps pourvu de l'unité d'éclairage.

15. Source de lumière d'exposition (28) pour un appareil de formation d'image électrophotographique (40), comprenant :
le dispositif électroluminescent organique (26) selon l'une quelconque des revendications 1 à 9.
